# EUROPÄISCHE PATENTSCHRIFT

(11) **EP 3 997 029 B1**
(45) Veröffentlichungstag und Bekanntmachung des Hinweises auf die Patenterteilung: **20.12.2023**
(21) Anmeldenummer: 20739915.5
(22) Anmeldetag: 07.07.2020
(51) Int. Cl.: B81B 3/00, G02B 26/08

(54) **MEMS-AKTUATOR-ELEMENT UND MEMS-AKTUATOR-ARRAY MIT EINER MEHRZAHL VON MEMS-AKTUATOR-ELEMENTEN**
MEMS ACTUATOR ELEMENT AND MEMS ACTUATOR ARRAY WITH A MULTIPLICITY OF MEMS ACTUATOR ELEMENTS
ÉLÉMENT D'ACTIONNEUR DE TYPE MEMS ET RÉSEAU D'ACTIONNEURS DE TYPE MEMS AYANT UNE PLURALITÉ D'ÉLÉMENTS D'ACTIONNEUR DE TYPE MEMS

(30) Priorität: 08.07.2019 DE 102019210020
(43) Veröffentlichungstag der Anmeldung: 18.05.2022
(73) Patentinhaber: Fraunhofer-Gesellschaft zur Förderung der angewandten Forschung e.V., 80686 München (DE)
(72) Erfinder: DÜRR, Peter, 01109 Dresden (DE); NEUDERT, Andreas, 01109 Dresden (DE); FELSBERG, Linda, 72762 Reutlingen (DE)
(74) Vertreter: Hersina, Günter
(86) Internationale Anmeldenummer: PCT/EP2020/069101
(87) Internationale Veröffentlichungsnummer: WO 2021/005045

(56) Entgegenhaltungen:
- US-A1- 2006 119 216
- HAH D ET AL: "Low-Voltage, Large-Scan Angle MEMS Analog Micromirror Arrays With Hidden Vertical Comb-Drive Actuators", JOURNAL OF MICROELECTROMECHANICAL SYSTEMS, IEEE SERVICE CENTER, US, Bd. 13, Nr. 2, 1. April 2004 (2004-04-01), Seiten 279-289, XP011110390, ISSN: 1057-7157, DOI: 10.1109/JMEMS.2004.825314

## Beschreibung

Die vorliegende Erfindung bezieht sich auf ein MEMS-Aktuator-Element (MEMS = mikroelektromechanisches System) und dessen Aufbau und ferner auf ein MEMS-Aktuator-Array mit einer Mehrzahl von MEMS-Aktuator-Elementen. Ausführungsbeispiele beziehen sich ferner auf ein MEMS-Aktuator-Element mit Kammantrieb und verbesserter Linearität.

MEMS-Aktuator-Elemente (im Folgenden einfach auch Aktuatoren) gemäß Ausführungsbeispielen können für eine breite Palette von Anwendungen eingesetzt werden, wie z.B. Scannerspiegel, optische Schalter für die Kopplung von Lichtleitfasern (optical crossconnect), Mikroventile, elektrische Mikroschalter und andere. Eine besonders relevante Anwendung sind Flächenlichtmodulatoren, bei denen die Aktuatoren, meist als 2-dimensionales Array, damit verbundene Mikrospiegel bewegen und wie gewünscht positionieren.

Im Folgenden wird auf den technischen Hintergrund eingegangen, wobei entsprechende Erkenntnisse und Schlussfolgerungen der Erfinder bzgl. des technischen Hintergrunds z.B. unter Bezugnahme auf die zitierten Referenzen zusammengefasst dargestellt werden.

Meistens wird die Position eines beweglichen Aktuatorteils durch ein angelegtes elektrisches Signal gesteuert. Als physikalischer Effekt wird in vielen Fällen die elektrostatische Anziehungskraft genutzt, aber auch elektromagnetische Kräfte sowie piezoelektrische oder thermische Ausdehnung können eingesetzt werden.

Aufgrund der Art der ausführbaren Bewegung unterscheidet man zwischen drehenden bzw. kippenden Aktuatoren und translatorischen Aktuatoren, sowie Aktuator-Typen, die beide Bewegungsarten ermöglichen. Im letzten Fall können die Bewegungskomponenten entweder durch die Art der Aufhängung fest gekoppelt sein, oder durch mehrere Ansteuersignale individuell eingestellt werden (z.B. piston-tip-tilt). Diese Erfindung kann für alle diese Bewegungsarten genutzt werden. In der nachfolgenden Beschreibung der Ausführungsbeispiele wird beispielsweise auf translatorischen Aktuatoren eingegangen, speziell solche, die mit Mikrospiegeln zur Phaseneinstellung von daran reflektiertem Licht gekoppelt sind. Die Beschreibung ist aber gleichermaßen auf Dreh- bzw. Kipp-Aktuatoren anwendbar.

Oft sind solche Aktuatoren in großer Anzahl dicht gepackt auf einem Trägersubstrat in einer Ebene angeordnet und die gewünschte Auslenkungsrichtung ist senkrecht zu dieser Ebene. Dies bezeichnet man auch als Mikrospiegelarray. Die Form und Größe der Mikrospiegel und die nötige Auslenkung sind meist von der Anwendung und optischen Randbedingungen bestimmt. Kleine Spiegel erlauben dabei große Beugungswinkel und sind daher oft bevorzugt. Ihre Größe limitiert aber auch den verfügbaren Platz für die darunter liegende Speicherzelle der elektronischen Ansteuerung sowie für die konstruktive Auslegung des Aktuators und damit die mögliche Antriebskraft. Die dichte Packung begünstigt ebenfalls ein Übersprechen, so dass ein Aktuator in ungünstiger Weise auch auf das Ansteuersignal der benachbarten Aktuatoren reagieren kann.

Bei den bisher bekannten elektrostatisch angesteuerten analogen Mikrospiegelarrays mit hoher bis sehr hoher Pixelanzahl (z.B. etwa >>1000 bis zu einigen Millionen) werden üblicherweise Plattenaktuatoren verwendet [2, 3). Diese sind relativ einfach im Design und in der Fertigung und können ausreichende Lösungen darstellen, solange die einzelnen Pixel noch deutlich größer sind, als etwa das 20-fache der gewünschten Auslenkung. Bei Plattenaktuatoren ist das Feld in brauchbarer Näherung homogen und der bewegliche Teil lässt sich weitgehend in Feldrichtung auslenken.

Plattenaktuatoren zeigen jedoch den bekannten pull-in-Effekt, der bei parallelen Platten alle Positionen ab einer Auslenkung von einem Drittel des Anfangsabstandes der Platten bei 0V angelegter Spannung instabil und damit nicht nutzbar macht [2]. Tatsächlich ist die Auslenkungskennlinie in der Näher des pull-in-Zustands bereits so steil, dass in der Praxis nur ein deutlich kleinerer Bereich des Anfangsabstandes genutzt werden kann, etwa nur 20%, evtl. 25%. Benötigt man z.B. zur Phasenmodulation von sichtbarem Licht eine Auslenkung von mindestens 320 nm (2π Modulationsbereich), so ergibt sich ein Anfangsabstand von mindestens 1,3 µm, eher 1,6 µm. Dieser große Abstand ergibt recht kleine elektrostatische Kräfte (da die Kraft proportional zum Kehrwert des Quadrats des Abstands sinkt) und für Pixelgrößen deutlich unter 10µm ein kaum noch beherrschbares Übersprechen der Nachbarpixel.

Bei Mikrospiegelarrays mit sehr vielen Pixeln ist es oft vorteilhaft, die wirkende Adressspannung in zwei Beiträge zu trennen: eine feste, für alle (oder sehr viele) Pixel gleiche Spannung, die Biasspannung genannt wird und zu einer von der spannungsfreien Ruhelage verschiedenen Ausgangslage der Aktuatoren führt, sowie eine jedem individuellen Pixel eigene, je nach gewünschter Position unterschiedliche Adressspannung, die zwischen 0V und einem Maximalwert eingestellt werden kann. Die Bereitstellung der Biasspannung kann bei begrenztem Adressspannungsbereich eine größere Aktuatorkraft bei maximaler Auslenkung erzeugen, so dass härtere Federn zu Einsatz kommen können. Zudem wird die Linearität der Kennlinie verbessert. Andererseits verkleinert sich der nutzbare Auslenkungsbereich eines gegebenen Aktuators zwischen der durch die Biasspannung gegebenen Ausgangslage und der durch den Sicherheitsabstand vom pull-in-Punkt gegebenen Endlage des Aktuators. Dies muss im Allgemeinen durch einen weiter vergrößerten Abstand der Elektroden erkauft werden, was ein nochmals größeres Übersprechen zur Folge hat. Zudem wird der Vorteil der höheren Kraftentfaltung durch den größeren Elektrodenabstand teilweise wieder aufgezehrt.

Elektrostatische Kammantriebe werden dagegen bisher meist in Mikrosystemen mit einzelnen oder wenigen, größeren Mikrospiegeln (oder anderen bewegten Bauteilen wie z.B. der Masse bei Inertialsensoren) eingesetzt, z.B. [4, 7]. Die dabei üblichen Bulk-mikromechanischen Fertigungsmethoden haben meist Strukturgrößen (z.B. Fingerbreiten) von mehreren Mikrometern und eignen sich nicht gut für Pixel, die insgesamt nur einige wenige Mikrometer groß sein sollen.

Kammantriebe können für eine Aktuatorauslenkung parallel zu den Elektrodenebenen bzw. Fingern ausgelegt sein oder alternativ im Wesentlichen senkrecht dazu. Letzteres wird gerne als vertikaler Kammantrieb bezeichnet, da die Elektrodenebenen meist als Fertigungsebenen parallel zu einer Oberfläche eines Substrats liegen. In diesem Fall ist die Bewegung des Aktuators nach beiden Seiten nicht eingeschränkt und es können im resonanten Betrieb sehr große Auslenkungen erreicht werden [4]. Ein derartiger vertikaler Kammantrieb ist auch aus US 2006/119216 A1 bekannt. Der dort beschriebene Aktuator ist für einen resonanten Betrieb ausgelegt.

Selbstverständlich können gemäß Ausführungsbeispielen die Aktuatoren je nach Fertigungstechnik auch anders orientiert sein, die Argumentation gilt dann entsprechend, wobei gemäß Ausführungsbeispielen der vorliegenden Erfindung derartige vertikale Kammantriebe für die skizzierten Randbedingungen optimiert werden.

Die bekannten Mikrosysteme mit vertikalem Kammantrieb kann man einteilen in solche, bei denen die Elektroden (Kämme) nach Fertigstellung und ohne angelegte Spannung in einer gemeinsamen Ebene liegen und andere, bei denen die statischen und beweglichen Elektroden jeweils in einer eigenen Ebene liegen. Letzteres kann erreicht werden, indem die Elektroden direkt in verschiedenen Ebenen hergestellt werden z.B. [5], indem der eine Teil der Elektroden durch einen späten Schritt im Fertigungsablauf aus ihrer ursprünglichen Position in eine neue Ruhelage gebracht werden, z.B. [6], oder indem die beiden Elektroden an unterschiedlichen Seiten durch eine gesonderte Ätzung jeweils gekürzt werden z.B. [7]. In allen diesen Fällen entsteht ein Aktuator, der sich beim Anlegen einer statischen Adressspannung analog auslenken lässt. Dagegen kann ein Aktuator mit beiden Elektroden in einer Ebene nur resonant angeregt werden und wäre für die vorliegende Aufgabe nicht geeignet.

Im Fall der Elektroden in zwei Ebenen sind im Stand der Technik solche bekannt, die sich in Ruhelage (ohne angelegte Spannung) bereits überlappen bzw. in einander eingetaucht sind, d.h. die untere Kante des oberen Elektrodenkammes liegt tiefer als die obere Kante des unteren Kammes, wobei die Finger jeweils in den Lücken des anderen Kammes liegen. Dies wird so gewählt, da ein Kammantrieb bei gegebenem Design und gegebener Adressspannung seine volle Kraft erst entfaltet, wenn die Kämme in einander eingetaucht sind. Bei ausreichend tiefem Eintauchen ist auch die Berechnung der Kraft i. A. recht einfach und das System daher i. A. leicht zu verstehen und zu dimensionieren.

Kammantriebe haben den Vorteil, dass sie in der gewünschten Arbeitsrichtung keinen pull-in-Zustand aufweisen und die Auslenkung daher sogar größer sein kann, als der Ruheabstand der Elektroden. Auch hier ist die gewünschte vertikale Kraft umso größer, je kleiner der horizontale Abstand der Elektrodenkanten ist. Eine untere Schranke für den horizontalen Elektrodenabstand ergibt sich jedoch durch die sehr viel größeren horizontalen Kräfte, die die einzelnen Finger aufeinander ausüben. Bei perfekt gefertigten Systemen addieren sich zwar alle horizontale Kräfte zu Null, aber bereits kleinste Ungenauigkeiten können zu enormen horizontalen Nettokräften führen, die einen solchen Aktuator sogar zerstören können (horizontaler pull-in). Dieser Effekt ist umso kritischer, je größer der Elektrodenüberlapp ist. Letzterer ist natürlich bei Vollauslenkung des Aktuators nochmals größer als in Ruhelage.

Es gibt ebenfalls bekannte Systeme, bei denen die Elektroden in Ruhelage 'Kante auf Kante' liegen oder solche, bei denen ein geringer vertikaler Abstand vorliegt. Letzterer ist meist fertigungsbedingt als Folge einer Ätzstoppschicht oder Verbindungsschicht zwischen den Ebenen aus denen die Elektroden gefertigt wurden. Ein solcher Abstand wird als geringfügiger Nachteil zur Vereinfachung der Fertigung in Kauf genommen, das Potenzial zur Optimierung des Aktuators wurde bisher aber nicht erkannt.

In allen elektrostatischen Aktuatoren ist die Aktuatorkraft bei gegebener Konfiguration und Auslenkung proportional zum Quadrat der Spannung. Zusätzlich steigt die Kraft mit Annäherung der Aktuatorteile aneinander weiter, was meistens eine unerwünscht stark nichtlineare Auslenkungskennlinie ergibt. Eine Möglichkeit der Linearisierung der Kennlinie ist in [1] beschrieben. Leider lässt sie sich bei sehr kleinen Pixeln ggf. nur schwer anwenden.

Die hier vorliegende Aufgabe besteht also darin, eine große Auslenkung und große Aktuatorkraft bei sehr kleinen, dicht gepackten Aktuatoren zu erreichen, wobei die Auslenkungskennlinie (d.h. die Aktuatorposition vs. Adressspannung) möglichst nah an der Linearität sein soll und ein Übersprechen zwischen Nachbarpixeln möglichst klein sein soll.

Diese Aufgabe wird durch den unabhängigen Patentanspruch gelöst. Erfindungsgemäße Weiterbildungen sind in den Unteransprüchen definiert.

Gemäß der Erfindung weist ein MEMS-Aktuator-Element folgende Merkmale auf: ein Substrat, eine erste Elektrodenstruktur mit einer Kantenstruktur, die bezüglich des Substrats feststehend angeordnet ist, eine zweite Elektrodenstruktur mit einer Kantenstruktur, wobei die zweite Elektrodenstruktur mittels einer Federstruktur auslenkbar mit dem Substrat gekoppelt ist und mittels einer Ansteuerspannung zwischen der ersten und zweiten Elektrodenstruktur elektrostatisch auslenkbar ist, um die Kantenstruktur der zweiten Elektrodenstruktur in eine Zwischenposition zwischen einer minimalen Auslenkungsposition und einer vertikal beabstandeten maximalen Auslenkungsposition zu bewegen, wobei die minimale und maximale Auslenkungsposition einen maximalen Auslenkungsweg (= Stroke) vorgeben, wobei die Kantenstrukturen der ersten und zweiten Elektrodenstruktur hinsichtlich einer Draufsicht gegenüberstehend ausgebildet und in der minimalen Auslenkposition vertikal voneinander beabstandet sind, und wobei die erste und zweite Elektrodenstruktur in einer Ebene parallel zu dem Substrat um einen lateralen Mindestabstand beabstandet sind, wobei der laterale Mindestabstand das 0,5-bis 1 ,5-fache des maximalen Auslenkungswegs beträgt, und wobei die vertikale Dicke der ersten und/oder zweiten Elektrodenstruktur das 0,6- bis 1 ,2-fache des maximalen Auslenkungswegs beträgt, und wobei in der maximalen Auslenkposition der vertikale Eintauchweg z₁ der Kantenstruktur der zweiten Elektrodenstruktur in die Kantenstruktur der ersten Elektrodenstruktur bis zu dem 0,5-fachen des maximalen Auslenkungswegs z₀, mit z₁ ≤ 0,5 z₀, beträgt, und eine Ansteuereinrichtung, ausgebildet zum Bereitstellen der Ansteuerspannung begrenzt durch eine minimale Ansteuerspannung und eine maximale Ansteuerspannung zwischen der ersten und zweiten Elektrodenstruktur, um basierend auf der elektrischen Ansteuerspannung die zweite Elektrodenstruktur in die Zwischenposition zwischen der minimalen Auslenkungsposition und der maximalen Auslenkungsposition elektrostatisch auszulenken, wobei eine minimale Ansteuerspannung eine Auslenkung der Kantenstruktur der zweiten Elektrodenstruktur in die minimale Auslenkungsposition und eine maximale Ansteuerspannung eine Auslenkung in die maximale Auslenkungsposition bewirkt. Die vertikale Richtung ist hierbei senkrecht zur Substratebene.

Die vorliegende Erfindung umfasst auch ein MEMS-Aktuator-Array mit einer Mehrzahl von den erfindungsgemäßen MEMS-Aktuator-Elementen wobei die Ansteuereinrichtung ausgebildet ist, um eine eigene Ansteuerspannung zwischen der ersten und zweiten Elektrodenstruktur der jeweiligen MEMS-Aktuator-Elemente bereitzustellen.

Ausführungsbeispiele sind insbesondere auf mikromechanische Aktuatoren anwendbar, die elektrostatisch angesteuert werden und über eine rückstellende elastische Aufhängung verfügen, die für eine statische Gleichgewichts-Auslenkung eine entsprechende Gegenkraft aufbringt. Die Auslenkung kann damit in einem vorgegebenen Bereich nach Wunsch kontinuierlich eingestellt werden und muss nicht durch mechanische Anschläge beschränkt sein.

Ausführungsbeispiele beziehen sich daher z.B. auf solche Aktuatoren, die oft als Kammantrieb (comb drive) bezeichnet werden, bei denen inhomogene Randfelder die entscheidende Rolle spielen und sich der bewegliche Teil weitgehend quer zur Richtung des stärksten Teils des elektrischen Feldes auslenken lässt. Das elektrostatische Feld ist bei Kammantrieben durch den kleinen Elektrodenabstand räumlich eng um die Elektrodenfinger begrenzt.

Dies sorgt für Aktuatorkräfte, die im Vergleich zu einem Plattenaktuator in der gleichen Pixelfläche wesentlich größer ausfallen können, auch wenn bei fertigungsbedingter gegebener Minimalgröße der Strukturen nur einige wenige Finger möglich sind. Allein dies ist bereits ein entscheidender Vorteil, da damit stärkere Federn und ein schnelleres Ansprechen des Aktuators möglich sind. Oberflächen-Mikromechanik erlaubt dabei wesentlich feinere Strukturen im Vergleich zur Bulk-Mikromechanik und ist daher bevorzugt. Dazu erlaubt der Kamm- bzw. Kantenantrieb ein geringes Übersprechen.

Dafür kann es besonders günstig sein, eine der Elektrodenstrukturen mit dem gemeinsamen Potenzial aller Pixel an den Rand des Pixels zu legen. Wenn dies die feste Elektrode ist, kann diese direkt mit der Elektrode des Nachbarpixels verbunden werden, was entsprechend wenig Platz verbraucht.

Zur Linearisierung der Kennlinie bei erträglichem Verlust an maximaler Aktuatorkraft ergeben sich besonders gute Gesamtergebnisse, wenn die Designparameter wie folgt optimiert werden (je nach Gewichtung der verschiedenen Zielparameter): in der Endlage (= maximale Auslenkposition), der gewünschten Vollauslenkung bei maximaler Adressspannung (= Betriebsspannung), entsteht ein nur geringer Überlapp (= Eintauchtiefe) der statischen und beweglichen Elektrodenebenen von nur näherungsweise 0% bis 50% des Strokes (= Auslenkungsbereich zwischen minimaler und maximaler Adressspannung), oder von 10% bis 40%, oder von 20% bis 30%. Ein großer Teil des Auslenkungsbereichs findet daher mit nicht überlappenden Elektroden statt. Der horizontale Elektrodenabstand wird mit 50% bis 150% des Strokes gewählt, oder 60% bis 100%, und die Dicke der Elektroden (= Ausdehnung in Auslenkungsrichtung) wird mit 60% bis 120% des Strokes, oder von 80% bis 100% gewählt. Die Biasspannung kann vorteilhaft im Bereich von 50% bis 200%, oder von 80% bis 150%, des für die Pixel individuellen Adressspannungsbereichs liegen.

Der horizontale Elektrodenabstand ist beispielsweise der mittlere oder durchschnittliche (d.h. wirksame oder effektive) horizontale (d.h. laterale) Elektrodenabstand der ersten und zweiten Elektrodenstruktur in einer Ebene parallel zu einem Hauptoberflächenbereich des Substrats. Entsprechend ist die vertikale Dicke der ersten und zweiten Elektrodenstruktur beispielsweise die mittlere oder durchschnittliche (d.h. wirksame oder effektive) Dicke der ersten und zweiten Elektrodenstruktur.

Basierend auf den obigen Designparametern für das MEMS-Aktuator-Element kann nun die für die jeweilige Anwendung gewünschte bzw. geforderte maximale Auslenkung zₛ (Stroke) des MEMS-Aktuatorelements mit kleinen Abmessungen (Pitch), einer relativ niedrigen Antriebsspannung und einer (möglichst) linearen Kennlinie des MEMS-Aktuatorelements erhalten werden. Der resultierende maximale Auslenkungsweg des MEMS-Aktuator-Elements kann somit an die durch die Anwendung geforderte Größe unter Beibehaltung der Randparameter (kleine Abmessungen, kleine Antriebsspannung und lineare Kennlinie) erhalten werden, wobei typische Anwendungen für das MEMS-Aktuator-Element beispielweise Scannerspiegel, optische Schalter für die Kopplung von Lichtleitfasern, Mikroventile, elektrische Mikroschalter oder Flächenlichtmodulatoren sein können. Bei Flächenlichtmodulatoren sind die MEMS-Aktuator-Elemente häufig als 2-dimensionales Array ausgebildet und bewegen bzw. positionieren damit mechanisch verbundene Mikrospiegel.

Im Gegensatz zum Stand der Technik, bei dem der Maximalbereich des Strokes zwischen der minimalen Auslenkungsposition im spannungsfreien Zustand (oder an einem mechanischen Anschlag) und der maximalen Auslenkungsposition mit einer maximalen bzw. symmetrischen Überlappung der ersten und zweiten Elektrodenstruktur (auch: symmetrisches Eintauchen) vorliegt, kann gemäß Ausführungsbeispielen des vorliegenden Konzepts durch die definierten Designparameter des MEMS-Aktuator-Elements ein möglichst großer nutzbarer Auslenkungsweg (= der gewünschte maximale Auslenkungsweg, der durch den jeweiligen Anwendungsfall vorgegeben wird) erhalten und eingestellt werden, wobei das resultierende MEMS-Aktuator-Element für den Anwendungsfall minimale Abmessungen (Pitch), minimale Antriebsspannungen mit einem relativ geringen Übersprechen zu Nachbarpixeln und eine hohe Linearität der Kennlinie im gesamten Auslenkungsbereich des MEMS-Aktuator-Elements aufweisen kann.

Ausführungsbeispiele werden nachfolgend Bezug nehmend auf die beiliegenden Zeichnungen erläutert. Es zeigen:
- Fig. 1a: eine schematische perspektivische Ansicht eines MEMS-Aktuator-Elements gemäß einem Ausführungsbeispiel;
- Fig. 1b: eine schematische Teilquerschnittsansicht durch einen Abschnitt der Kantenstruktur der ersten Elektrodenstruktur und einen gegenüberliegenden Abschnitt der Kantenstruktur der zweiten Elektrodenstruktur gemäß einem Ausführungsbeispiel;
- Fig. 2a: die schematische Teilquerschnittsansicht von Fig.1b mit einer resultierenden Konzentration des elektrischen Feldes zwischen der Kantenstruktur der ersten Elektrodenstruktur und einem gegenüberliegenden Abschnitt der Kantenstruktur der zweiten Elektrodenstruktur;
- Fig. 2b: die schematische Teilquerschnittsansicht von Fig.1b durch zwei benachbarte MEMS-Aktuator-Elemente 10 gemäß einem Ausführungsbeispiel.
- Fig. 3: eine schematische, resultierende Kennlinie der Auslenkung zu Ansteuerspannung eines MEMS-Aktuator-Elements gemäß einem Ausführungsbeispiel;
- Fig. 4: eine schematische Draufsicht eines rechteckigen MEMS-Aktuator-Elements (Einheitszelle für ein Array) mit einem einseitig eingespannten Federelement (Cantilever) der Federstruktur gemäß einem Ausführungsbeispiel;
- Fig. 5a: eine schematische perspektivische Ansicht eines MEMS-Aktuator-Elements gemäß einem weiteren Ausführungsbeispiel;
- Fig. 5b: eine schematische Teilquerschnittsansicht durch einen Abschnitt der Kantenstruktur der ersten Elektrodenstruktur und einen gegenüberliegenden Abschnitt der Kantenstruktur der zweiten Elektrodenstruktur gemäß einem Ausführungsbeispiel;
- Fig. 6: eine schematische partielle Querschnittsansicht durch einen Teil eines MEMS-Aktuator-Elements gemäß einem Ausführungsbeispiel, wobei das MEMS-Aktuator-Element als ein doppelt wirkender Aktuator ausgebildet ist;
- Fig. 7: eine schematische Querschnittsansicht senkrecht zu einer Kippachse durch einen Teil eines MEMS-Aktuator-Elements gemäß einem Ausführungsbeispiel, wobei das MEMS-Aktuator-Element als ein Kipp-Aktuator ausgebildet ist;
- Fig. 8: eine schematische Querschnittsansicht senkrecht zu einer Kippachse durch einen Teil eines MEMS-Aktuator-Elements gemäß einem Ausführungsbeispiel, wobei das MEMS-Aktuator-Element als ein doppeltwirkender Kipp-Aktuator ausgebildet ist;
- Fig. 9: eine schematische Aufsicht auf ein regelmäßiges Array von MEMS-Aktuator-Elementen gemäß einem Ausführungsbeispiel.

Die Ausführungsbeispiele dienen der Erläuterung der verschiedenen Merkmale und Ausführungen der Erfindung. Sie sind auch Ausführungsbeispiele der Erfindung selbst sobald das entsprechende Aktuator-Element insgesamt entsprechend dem Anspruch 1 ausgeführt ist.

Bevor nachfolgend Ausführungsbeispiele des vorliegenden Konzepts im Detail anhand der Zeichnungen näher erläutert wird, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte untereinander austauschbar ist bzw. aufeinander angewendet werden kann.

Verschiedene Ausführungsbeispiele werden nun ausführlicher Bezug nehmend auf die beiliegenden Zeichnungen beschrieben, in denen einige Ausführungsbeispiele dargestellt sind. In den Figuren können Abmessungen von dargestellten Elementen, Schichten und/oder Bereichen zur Verdeutlichung nicht maßstäblich dargestellt sein.

Es versteht sich, dass, wenn ein Element als mit einem anderen Element "verbunden" oder "gekoppelt" bezeichnet wird, es direkt mit dem anderen Element verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.).

Zur Vereinfachung der Beschreibung der unterschiedlichen Ausführungsbeispiele weisen die Figuren ein kartesisches Koordinatensystem x, y, z auf, wobei die die x-y-Ebene dem Hauptoberflächenbereich des Trägers bzw. Substrats entspricht bzw. parallel zu demselben ist und wobei die vertikale Richtung senkrecht zu der x-y-Ebene ist. In der folgenden Beschreibung bedeutet der Ausdruck "lateral" oder horizontal eine Richtung in der x-y-Ebene (oder parallel dazu), wobei der Ausdruck "vertikal" eine Richtung in der ±z-Richtung (oder parallel dazu) angibt.

Nachfolgende Beispiele beziehen sich auf mikroelektromechanische Systeme (MEMS), die dazu ausgelegt sind, eine bewegliche Elektrodenstruktur auszulenken, die mechanisch mit einem Funktionselement gekoppelt sein kann. Obwohl sich nachfolgende Ausführungsbeispiele auf bewegliche Funktionselemente beziehen, die einen Spiegel, insbesondere einen Mikrospiegel umfassen, so können auch beliebige andere Funktionselemente angeordnet werden, sowohl im optischen Bereich, etwa Linsen, Filter oder dergleichen, aber auch in anderen Bereichen, etwa zum Herstellen eines elektrischen Kontaktes oder dem Verändern eines mechanischen Abstandes.

MEMS können in Halbleitertechnologie hergestellt sein, wobei hierfür insbesondere mehrschichtige Anordnungen in Betracht kommen, darunter leitende, isolierende und halbleitende Schichten, die durch ebensolche Schichten oder Luftspalte beabstandet sein können. MEMS können beispielsweise durch einen mehrschichtigen Lagenaufbau erhalten werden, welcher durch selektives Entfernen von Stapelmaterial, beispielsweise durch einen Ätzprozess, reduziert wird, um MEMS-Strukturen freizulegen. Als Substrat kann beispielsweise ein Siliziummaterial, beispielsweise monokristallines Silizium, polykristallines Silizium oder ein dotiertes Siliziummaterial, verwendet werden. In unterschiedlichen Schichten kann eine Leitfähigkeit erzeugt werden, beispielsweise um die Funktionalität einer Elektrode bereitzustellen. Andere Schichten können beispielsweise metallisiert werden, etwa um eine reflektierende Oberfläche und/oder eine elektrisch leitfähige Oberfläche herzustellen.

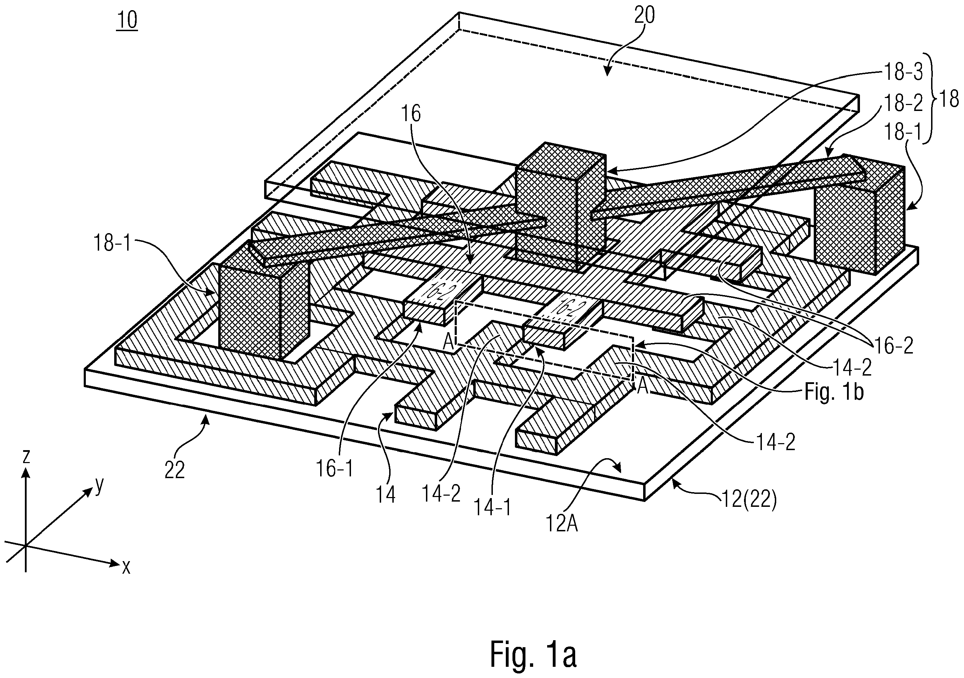

Im Folgenden wird anhand der Fig. 1a-b eine beispielhafte Ausgestaltung eines MEMS-Aktuator-Elements 10 gemäß einem Ausführungsbeispiel erläutert.

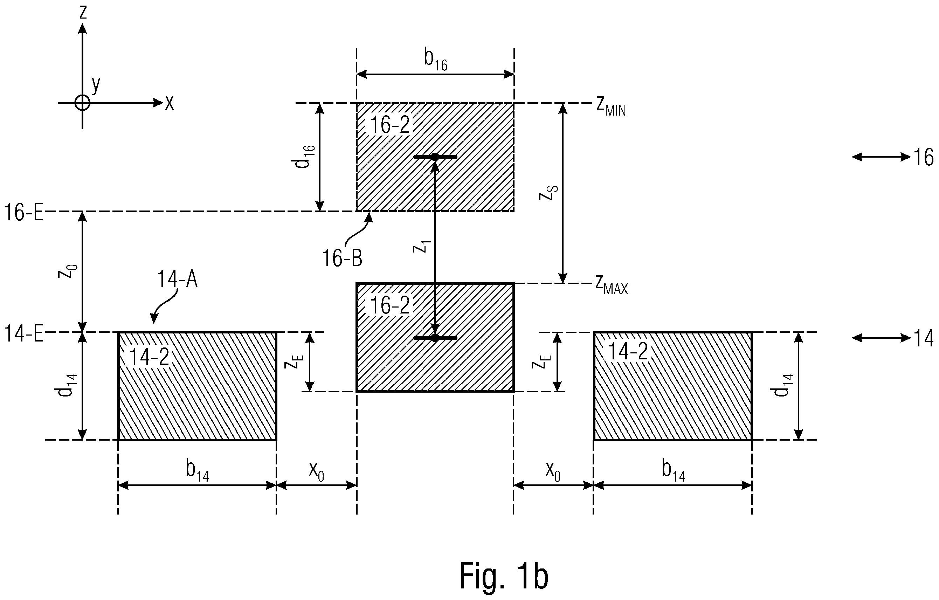

Fig. 1a zeigt eine schematische perspektivische Ansicht des MEMS-Aktuator-Elements 10 gemäß einem Ausführungsbeispiel, während Fig. 1b eine schematische Teilquerschnittsansicht entlang einer Schnittlinie A-A in Fig. 1a und parallel zu der x-z-Ebene durch einen Abschnitt der Kantenstruktur 14-1 der ersten Elektrodenstruktur 14 und einen gegenüberliegenden Abschnitt der Kantenstruktur 16-1 der zweiten Elektrodenstruktur 16 zeigt.

Das MEMS-Aktuator-Element 10 umfasst ein Substrat 12, beispielsweise einen vollständigen Wafer bzw. Halbleiter-Wafer oder alternativ einen teilweise oder ganz vereinzelten Abschnitt des Wafers. Das Substrat 12 kann einen Hauptoberflächenbereich 12-A parallel zu der Substratebene (parallel zur x-y-Ebene) ausbilden und sich zumindest teilweise in der Substratebene erstrecken. Die Substratebene ist beispielsweise parallel zu einer Hauptseite 12-A eines Wafers (nicht gezeigt in Fig. 1a) angeordnet, die vereinfacht als Oberseite oder Unterseite bezeichnet werden kann, ohne dass diese Begriffe einschränkende Wirkung entfalten sollen, da Begriffe wie oben, unten, links, rechts, vorne, hinten und dergleichen basierend auf einer veränderlichen Orientierung des MEMS-Aktuator-Elements 10 im Raum veränderlich oder vertauschbar sind.

Das MEMS-Aktuator-Element 10 umfasst ferner eine erste Elektrodenstruktur 14 mit einer Kantenstruktur 14-1, wobei die erste Elektrodenstruktur 14 mit der Kantenstruktur 14-1 bezüglich des Substrats 12 feststehend angeordnet ist. Die erste Elektrodenstruktur 14 mit der Kantenstruktur 14-1 kann direkt an dem Hauptoberflächenbereich 12-A des Substrats 12 angeordnet sein.

Das MEMS-Aktuator-Element 10 umfasst ferner eine zweite Elektrodenstruktur 16 mit einer Kantenstruktur 16-1, wobei die zweite Elektrodenstruktur 16 mittels einer Federstruktur 18 auslenkbar mit dem Substrat 12 gekoppelt ist und mittels der ersten Elektrodenstruktur 14 elektrostatisch auslenkbar ist, um die Kantenstruktur 16-1 der zweiten Elektrodenstruktur 16 in eine Zwischenposition bzw. Auslenkungsposition z₁ zwischen einer minimalen Auslenkungsposition z_{MIN} und einer vertikal beabstandeten maximalen Auslenkungsposition z_{MAX} zu bewegen, wobei die minimale und maximale Auslenkungsposition z_{MIN}, z_{MAX} einen maximalen Auslenkungsweg bzw. Stroke z_{S} vorgeben (siehe auch Fig. 1b). Der maximale Stroke z_{S} kann eine von der jeweiligen Aktuatoranwendung geforderte, feste Größe des MEMS-Aktuator-Elements 10 darstellen.

Bei dem MEMS-Aktuator-Element 10 sind die Kantenstrukturen 14-1, 16-1 der ersten und zweiten Elektrodenstruktur 14, 16 hinsichtlich einer Draufsicht, z.B. in einem lateralen Abstand x₀, gegenüberstehend ausgebildet und in der minimalen Auslenkposition z_{MIN} vertikal, z.B. in einem vertikalen Abstand z₀, voneinander beabstandet sind (siehe auch Fig. 1b).

Der laterale Abstand x₀ bezieht sich (in einer Draufsicht) auf lateral gegenüberliegende Abschnitte der Kantenstrukturen 14-1, 16-1 der ersten und zweiten Elektrodenstruktur 14, 16, während sich der vertikale Abstand z₀ auf vertikal versetzte, gegenüberliegende Randebenen 14-E, 16-E der Kantenstrukturen 14-1, 16-1 der ersten und zweiten Elektrodenstruktur 14, 16 bezieht. Dabei erstreckt sich die Randebene 14-E der ersten Elektrodenstruktur 14 entlang des oberen Hauptoberflächenbereichs 14-A der ersten Elektrodenstruktur 14, wobei sich die Randebene 16-E der zweiten Elektrodenstruktur 16 entlang des unteren Hauptoberflächenbereichs 16-B der zweiten Elektrodenstruktur 16 erstreckt. (siehe auch Fig. 1b)

Bei dem MEMS-Aktuator-Element 10 beträgt erfindungsgemäß in der maximalen Auslenkposition z_{MAX} der vertikale Eintauchweg "z_{E}" (oder Überlapp bzw. vertikaler Überlapp) der Kantenstruktur 16-1 der zweiten Elektrodenstruktur 16 in die Kantenstruktur 14-1 der ersten Elektrodenstruktur 14 bis zu dem 0,5-fachen des maximalen Auslenkungswegs zs, d.h. z_{E} ≤ 0,5 z_{S}.

Im Folgenden wird nun zunächst auf die in Fig. 1a-b dargestellte Ausführungsform des MEMS-Aktuator-Elements 10 eingegangen, bei der die zweite Elektrodenstruktur 16 translatorisch bezüglich der ersten Elektrodenstruktur 14 auslenkbar ist.

Wie in Fig. 1a beispielhaft dargestellt ist, kann die Federstruktur 18 zwei Pfosten bzw. Substratfortsätze 18-1 aufweisen, wobei ein Federelement 18-2 zwischen den beiden Pfosten 18-1 angeordnet ist, d. h., zwischen den beiden Pfosten 18-1 eingespannt bzw. an denselben gelagert ist und somit eine beidseitig eingespanntes Federelement 18-2 bildet. An dem Federelement 18-2 ist nun ferner ein Verbindungselement 18-3 angeordnet, das mechanisch mit der zweiten Elektrodenstruktur 16 verbunden ist. Das Federelement 18-2 stellt eine Federkraft ein, die beispielsweise der elektrostatisch bewirkten Auslenkung der zweiten Elektrodenstruktur 16 vertikal (in -z-Richtung) zu der ersten Elektrodenstruktur 14 entgegenwirkt.

Ausführungsbeispiele beziehen sich somit auf mikromechanische Aktuatoren 10, die elektrostatisch z.B. mit einer Biasspannung U_{BIAS} angesteuert werden und über eine rückstellende elastische Aufhängung 18 verfügen, die für eine statische Gleichgewichts-Auslenkung eine entsprechende Gegenkraft aufbringt, um die zweite Elektrodenstruktur 16 in die minimale Auslenkposition z_{MIN} zu bringen.

Das MEMS-Aktuator-Element 10 kann ferner ein Funktionselement 20 aufweisen, das mittels des Verbindungselementes 18-3 auch mit der zweiten Elektrodenstruktur 16 mechanisch fest gekoppelt ist. Das Funktionselement 20 kann ein Element sein, dessen translatorische und/oder rotatorische Position durch die elektrostatische Auslenkung zwischen der ersten und zweiten Elektrodenstruktur 14, 16 eingestellt, gesteuert oder zumindest beeinflusst werden kann. Beispielsweise kann das Funktionselement 20 ein Mikrospiegel und/oder eine elektrisch leitfähige Struktur sein.

Gemäß einem Ausführungsbeispiel kann das Verbindungselement 18-3 an einem Flächenschwerpunkt des Funktionselements 20 mechanisch mit demselben gekoppelt sein, wobei das Verbindungselement 18-3 ferner an einem Flächenschwerpunkt der zweiten Elektrodenstruktur 16 mit derselben mechanisch gekoppelt sein kann. Diese symmetrische Anordnung ist nur beispielhaft anzusehen, wobei andere Konfiguration gewählt werden können, wie dies in nachfolgenden Ausführungsbeispielen noch dargestellt wird.

Wie in Fig. 1a ferner beispielhaft dargestellt ist, kann die Kantenstruktur 16-1 der zweiten Elektrodenstruktur 16 hinsichtlich einer Draufsicht (und parallel zu der x-y-Ebene) ineinandergreifend zu der Kantenstruktur 14-1 der ersten Elektrodenstruktur 14 ausgebildet sein. So kann die Kantenstruktur 14-1 der ersten Elektrodenstruktur 14 eine Finger- oder Kammstruktur aufweisen, wobei die Kantenstruktur 16-1 der zweiten Elektrodenstruktur 16 eine weitere gegenüberliegende Finger- oder Kammstruktur aufweisen kann.

In diesem Fall wird beispielsweise auch von einem "Kammantrieb" (engl. comb drive), der durch die erste und zweite Elektrodenstruktur 14, 16 gebildet ist, gesprochen.

In diesem Zusammenhang wird aber darauf hingewiesen, dass der Begriff "Kammantrieb" nicht einschränkend zu verstehen ist, da auch für die erste und/oder zweite Elektrodenstruktur 14, 16 auch nur mit wenigen Finger- oder Kammelementen 14-2, 16-2 eingesetzt werden können.

Ferner können gemäß dem vorliegenden Funktionsprinzip die erste und/oder zweite Elektrodenstruktur 14, 16 als Kantenelemente ohne Finger- oder Kammelemente eingesetzt werden, wobei die erste und zweite Elektrodenstruktur 14, 16 gleichermaßen nach den hier beschriebenen Grundlagen funktionieren. So kann beispielsweise die erste Elektrodenstruktur 14 in einer Draufsicht (und parallel zur x-y-Ebene) als eine umlaufende Struktur zu der zweiten Elektrodenstruktur 16 ausgebildet sein. Allgemein kann dann auch von einem elektrostatischen Kantenaktuator-Element gesprochen werden, da die Aktuatorkraft proportional zu der Länge der sich gegenüberstehenden Kantenstrukturen 14-1, 16-1 der ersten und zweiten Elektrodenstruktur 14, 16 ist.

Soweit es die herstellbaren Strukturgrößen erlauben, sind daher eine Finger- oder Kammstruktur für die Kantenstruktur 14-1, 16-1 der ersten und zweiten Elektrodenstruktur 14, 16 effektiver einsetzbar, wobei in Fig. 1a gemäß einem Ausführungsbeispiel das MEMS-Aktuator-Element 10 eine erste und zweite Elektrodenstruktur 14, 16 mit nur wenigen Fingerelementen 14-2, 16-2 aufweist, so dass sich die resultierenden MEMS-Aktuator-Elemente 10 in der Substratebene dicht anordnen lassen und Pixelgrößen von beispielsweise nur dem rund 8- bis 16-fachen der Minimalstrukturgröße aufweisen können. Als Minimalstrukturgröße oder minimale Strukturgröße wird im Allgemeinen der Wert der kleinsten Struktur bezeichnet, die zuverlässig fotolithografisch hergestellt werden kann.

Fig. 1b zeigt eine schematische Teilquerschnittsansicht entlang der Schnittlinie A-A in Fig. 1a und parallel zu der x-z-Ebene durch einen Abschnitt der Kantenstruktur 14-1 der ersten Elektrodenstruktur 14 und einen vertikal gegenüberliegenden Abschnitt der Kantenstruktur 16-1 der zweiten Elektrodenstruktur 16 gemäß einem Ausführungsbeispiel. Anhand der Darstellung in Fig. 1b der Abschnitte bzw. Fingerelemente 14-2, 16-2 der Kantenstrukturen 14-1, 16-1 der ersten und der zweiten Elektrodenstruktur 14, 16 werden sowohl die relativen Positionen und Auslenkungswege der Kantenstrukturen 14-1, 16-1 der ersten und zweiten Elektrodenstruktur 14, 16 des MEMS-Aktuator-Elements 10 zueinander als auch typische Abmessungen der Kantenstrukturen 14-1, 16-1 der ersten und zweiten Elektrodenstruktur 14, 16 erläutert.

So sind in Fig. 1b zwei einzelne Fingerelemente 14-2 der Kantenstruktur 14-1 der ersten Elektrodenstruktur 14 und ein sich relativ dazu bewegendes Fingerelement 16-2 der Kantenstruktur 16-1 der zweiten Elektrodenstruktur 16 dargestellt. Die in Fig. 1b dargestellte Anordnung aus Fingerelementen 14-2, 16-2 der Kantenstrukturen 14-1, 16-1 ist (zumindest abschnittsweise) periodisch fortsetzbar, um die umlaufenden Kantenstrukturen 14-1, 16-1 der ersten und zweiten Elektrodenstruktur 14, 16 zu bilden.

Wie in Fig. 1b beispielhaft dargestellt ist, weisen die Fingerelemente 14-2 der ersten Elektrodenstruktur 14 eine vertikale Dicke d₁₄ (in z-Richtung) und eine laterale Breite b₁₄ auf. Das Fingerelement 16-2 der zweiten Elektrodenstruktur 16 weist eine vertikale Dicke d₁₆ und eine laterale (horizontale) Breite b₁₆ auf. Die gestrichelte Darstellung des Fingerelements 16-2 gibt beispielsweise eine minimale Auslenkungsposition (Grundposition) z_{MIN} der zweiten Elektrodenstruktur 16 wieder, während der durchgehend gezeichnete Umriss der Fingerstruktur 16-2 der zweiten Elektrodenstruktur 16 die maximale Auslenkposition z_{MAX} der zweiten Elektrodenstruktur 16 darstellt.

In der minimalen Auslenkposition z_{MIN} sind die Kantenstrukturen 14-1, 16-1 der ersten und zweiten Elektrodenstruktur 14, 16 vertikal (= parallel zur z-Richtung) in einem Abstand z₀ voneinander beabstandet sind, wobei in der maximalen Auslenkposition z_{MAX} das Fingerelement 16-2 der zweiten Elektrodenstruktur 16 vertikal zwischen die beiden Fingerelemente 14-2 der ersten Elektrodenstruktur "eingetaucht" ist. Bei dem MEMS-Aktuator-Element 10 beträgt in der maximalen Auslenkposition z_{MAX} der vertikale Eintauchweg "z_{E}" (oder Überlapp) der Kantenstruktur 16-1 der zweiten Elektrodenstruktur 16 in die Kantenstruktur 14-1 der ersten Elektrodenstruktur 14 bis zu dem 0,5-fachen des maximalen Auslenkungswegs zs, d.h. z_{E} ≤ 0,5 z_{S}. Die Wegstrecke zwischen der minimalen Auslenkungsposition z_{MIN} und der maximalen Eintauchposition z_{MAX} wird als maximaler Auslenkungsweg bzw. Stroke z_{S} bezeichnet, und erstreckt sich entlang der Auslenkungspositionen bzw. Auslenkungszwischenpositionen z₁mit 0 ≤ z₁ ≤ z_{S}, wobei die unterschiedlichen Auslenkungspositionen bzw. Auslenkungszwischenpositionen z₁ (zwischen z_{MIN} und z_{MAX}) als gestrichelte Linie angegeben sind. Bei dem MEMS-Aktuator-Element 10 sind die Kantenstrukturen 14-1, 16-1 der ersten und zweiten Elektrodenstruktur 14, 16 hinsichtlich einer Draufsicht in einem lateralen Abstand x₀ gegenüberstehend ausgebildet.

Gemäß einem Ausführungsbeispiel können das MEMS-Aktuator-Element 10 ein Mikrospiegelelement als das Funktionselement 20 aufweisen, das mit der zweiten Elektrodenstruktur 16 gekoppelt ist. Bei Anwendungen für sichtbares Licht können beispielsweise für eine Minimalstruktur folgende Abmessungen des MEMS-Aktuator-Elements 10 vorliegen: z_{S} = 320nm, z_{E} = z_{S}/4 = 80nm, z₀ = z_{S} - z_{E} = 240nm, z₀ = 0,8 z_{S} ≈ 250nm, d₁₄ = d₁₆ = 0,9 z_{S} = 300nm, b₁₄ = b₁₆ = 400nm. Diese Werte sind nur als beispielhaft anzusehen und können je nach Anwendungsgebiet des MEMS-Aktuator-Elements 10 variieren. Diese beispielhaften Werte können je nach Anwendungsgebiet des MEMS-Aktuator-Elements 10 beispielsweise um einen gemeinsamen Faktor von 0,5 bis 2 variieren, mit 160nm ≤ z_{S} ≤ 640nm oder um einen gemeinsamen Faktor von 0,8 bis 1,2 variieren, mit 256nm ≤ z_{S} ≤ 384nm.

Gemäß einem Ausführungsbeispiel sind also die erste und zweite Elektrodenstruktur 14, 16 ausgebildet, um basierend auf einer elektrischen Ansteuerspannung V_{S} die zweite Elektrodenstruktur 16 in eine Zwischenposition z₁ zwischen der minimalen Auslenkungsposition z_{MIN} und der maximalen Auslenkungsposition z_{MAX} elektrostatisch auszulenken. Dabei bewirkt ein Minimalwert der Ansteuerspannung V_{S} eine Positionierung oder Auslenkung der Kantenstruktur 16-1 der zweiten Elektrodenstruktur 16 in die minimale Auslenkungsposition z_{MIN} und ein Maximalwert der Ansteuerspannung Vs eine Auslenkung der Kantenstruktur 16-1 der zweiten Elektrodenstruktur 16 in die maximale Auslenkungsposition z_{MAX}. Der Ansteuerspannungsbereich (= Adressspannungsbereich) liegt zwischen der minimalen Wert V_{S-MIN} der Ansteuerspannung V_{S} und dem maximalen Wert V_{S_MAX} der Ansteuerspannung Vs.

Fermer bewirkt eine Änderung der Ansteuerspannung Vs in einen Spannungswert zwischen der minimalen Ansteuerspannung V_{S_MIN} und der maximalen Ansteuerspannung V_{S_MAX} eine entsprechende Änderung der Zwischenposition z₁ der Kantenstruktur 16-1 der zweiten Elektrodenstruktur 16 zwischen deren minimaler und maximaler Auslenkungsposition z_{MIN} und z_{MAX}.

Gemäß der Erfindung weist das MEMS-Aktuator-Element 10 ferner eine Ansteuereinrichtung 22 zum Bereitstellen der Ansteuerspannung V_{S} zwischen der ersten und zweiten Elektrodenstruktur 14, 16 des MEMS-Aktuator-Elements 10 auf. Die Ansteuereinrichtung 22 kann beispielsweise in das Halbeitermaterial des Substrats 12 integriert sein oder auch extern zu dem Substrat 12 angeordnet sein und elektrisch mit der ersten und zweiten Elektrodenstruktur 14, 16 verbunden sein. Gemäß einem Ausführungsbeispiel kann die Ansteuerspannung V_{S} einen Vorspannungsanteil (eine Biasspannung) V_{BIAS} und einen Betriebsspannungsanteil V_{BETRIEB} aufweisen.

Abhängig von dem Aufbau und der Dimensionierung der Elemente des MEMS-Aktuator-Elements 10 und insbesondere der Federstruktur 18 können für die Biasspannung V_{BIAS}, d. h. die minimale Ansteuerspannung, unterschiedliche, feste Werte gewählt werden. Wird beispielsweise die Bias-Spannung V_{BIAS} gleich 0 V (V_{BIAS} = 0 V) gewählt, entspricht die minimale Auslenkungsposition z_{MIN} der spannungsfreien Ruhelage der zweiten Elektrodenstruktur 16 bezüglich der ersten Elektrodenstruktur 14. Wird beispielsweise die Bias-Spannung V_{BIAS} ungleich 0 V (V_{BIAS} ≠ 0 V) gewählt, unterscheidet sich die minimale Auslenkungsposition z_{MIN} der zweiten Elektrodenstruktur 16 zu der ersten Elektrodenstruktur 14 von der spannungsfreien Ruhelage. Wie dies im Nachfolgenden noch näher erläutert wird, kann das Anlegen einer festen (= konstanten) Bias-Spannung V_{BIAS} ungleich 0 für eine erhöhte Linearität der Auslenkungskennlinie des MEMS-Aktuator-Elements 10 über der Ansteuerspannung V_{S} insbesondere im Bereich relativ geringer Auslenkungen z₁ aus der Ruhelage (= minimale Auslenkungsposition z_{MIN}) sorgen.

Gemäß der Erfindung ist das MEMS-Aktuator-Element 10 ausgelegt, so dass in der maximalen Auslenkungsposition z_{MAX} der vertikale Eintauchweg z_{E} der Kantenstruktur 16-1 der zweiten Elektrodenstruktur 16 bezüglich die Kantenstruktur 14-1 der ersten Elektrodenstruktur 14 bis zu dem 0,5-fachen des maximalen Auslenkungswegs z_{S}, d.h. z_{E} ≤ 0,5 z_{S} beträgt. Gemäß einem Ausführungsbeispiel kann der vertikale Eintauchweg z_{E} ferner zwischen dem 0,1- und 0,4-fachen oder zwischen dem 0,2- und dem 0,3-fachen des maximalen Auslenkungswegs z_{S} betragen.

Gemäß der Erfindung ist das MEMS-Aktuator-Element 10 ferner ausgelegt, so dass die erste und zweite Elektrodenstruktur 14, 16 in einer Ebene parallel zu dem Substrat 12 um einen lateralen Mindestabstand x₀ beabstandet sind, wobei der laterale Mindestabstand x₀ das 0,5- bis 1,5-fache oder das 0,6- bis 1-fache des maximalen Auslenkungswegs z_{S} beträgt.

Gemäß der Erfindung ist das MEMS-Aktuator-Element 10 ferner ausgelegt, so dass die vertikale Dicke d₁₄, d₁₆ der ersten und/oder zweiten Elektrodenstruktur 14, 16 das 0,6- bis 1,2-fache oder das 0,8- bis 1,0-fache des maximalen Auslenkungswegs z_{S} beträgt.

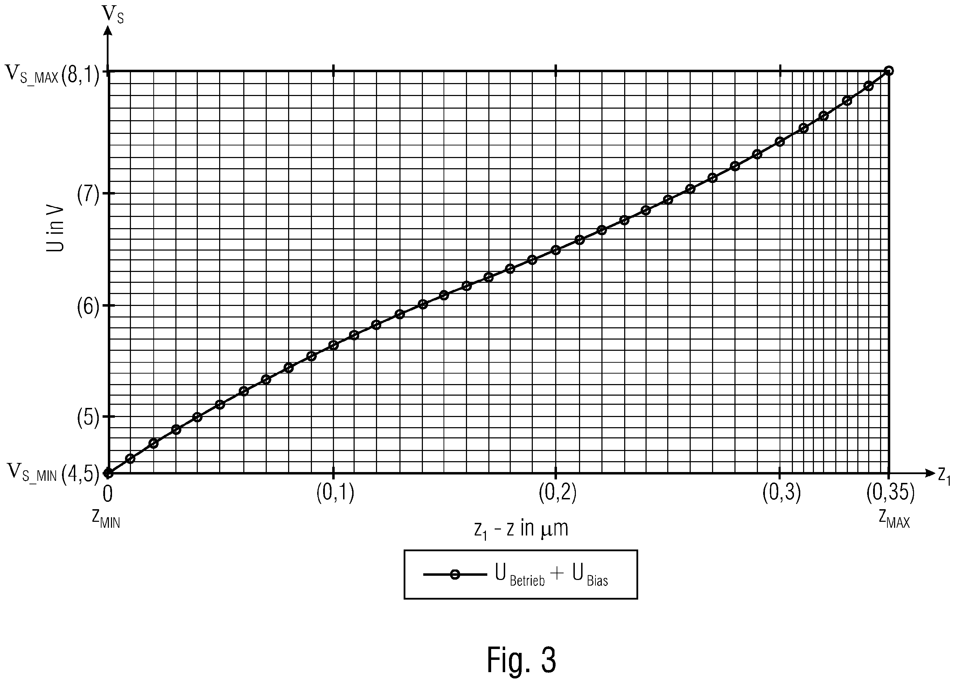

Gemäß einem Ausführungsbeispiel kann das MEMS-Aktuator-Element 10 ferner ausgelegt sein, so dass die minimale Ansteuerspannung als eine Biasspannung U_{BIAS} bereitgestellt wird, wobei die elektrische Ansteuerspannung V_{S} die Biasspannung U_{BIAS} und die Betriebsspannung (Adressspannung) V_{BETRIEB} aufweist, wobei die Biasspannung V_{BIAS} in einem Bereich zwischen dem 0,5-fachen bis 2-fachen oder dem 0,8-fachen bis 1,5-fachen des Betriebsspannungsbereichs liegen kann (siehe auch Fig. 3).

Bei Kammantrieben bzw. Kantenantrieben gemäß den beschriebenen Ausführungsbeispielen kann das elektrostatische Feld durch den relativ geringen Elektrodenabstand räumlich eng im Bereich der Elektrodenfinger 14-2, 16-2 begrenzt werden. Dadurch können relative hohe Aktuatorkräfte selbst bei der fertigungsbedingten Minimalgröße der Elektrodenstrukturen 14, 16 mit nur einigen wenigen Fingerelementen 14-2, 16-2 erreicht werden. Dazu erlaubt der beschriebene Kamm- bzw. Kantenantrieb ein geringes Übersprechen zwischen benachbarten Aktuatoren 10.

Gemäß einem Ausführungsbeispiel kann die Elektrodenstruktur mit dem gemeinsamen Potenzial U_{BIAS} aller Pixel bzw. Aktuatoren 10 an den Rand des Pixels 10 gelegt werden. Wenn dies die feste Elektrodenstruktur 14 ist, kann diese wie in Fig. 1a direkt mit der festen Elektrodenstruktur 14 des Nachbarpixels (nicht gezeigt in Fig. 1a) verbunden werden, wodurch ein sehr niedriger Platzbedarf erhalten wird.

Bezüglich der Darstellung in Fig. 1a wird darauf hingewiesen, dass dort etwas mehr als die Einheitszelle bzw. das Pixel 10 gezeigt ist, die/das sich in einem rechteckigen oder quadratischen Gitter dicht anordnen lässt. Dazu kann die Einheitszelle bzw. das Pixel 10 rechteckig oder quadratisch ausgebildet sein. Dabei fallen die Pfosten 18-1 von diagonal benachbarten Pixeln 10 auf einander. In die relativ klein ausgestaltbaren Pixelumrisse bzw. Pixelgrundflächen lassen sich beispielsweise nur relativ wenige Fingerelemente 14-2, 16-2 entsprechend der minimal herstellbaren Strukturauflösung anordnen.

Zur Linearisierung der Auslenkungskennlinie gegenüber dem Ansteuersignal V_{S} bei erträglichem Verlust an maximaler Aktuatorkraft ergeben sich besonders gute Gesamtergebnisse, wenn die Designparameter wie folgt optimiert werden (je nach Gewichtung der verschiedenen Zielparameter für das gewünschte Design und die gewünschte Funktionalität der MEMS-Aktuator-Elemente 10): in der Endlage (= maximale Auslenkposition), der gewünschten Vollauslenkung bei maximaler Adressspannung (= Betriebsspannung), entsteht ein nur geringer Überlapp (= Eintauchtiefe) der statischen und beweglichen Elektrodenebenen von nur näherungsweise 0% bis 50% des Strokes (= Auslenkungsbereich zwischen minimaler und maximaler Adressspannung), oder von 10% bis 40%, oder von 20% bis 30%. Ein großer Teil des Auslenkungsbereichs findet daher mit nicht überlappenden Elektroden statt. Der horizontale Elektrodenabstand wird mit 50% bis 150% des Strokes gewählt, oder 60% bis 100%, und die Dicke der Elektroden (= Ausdehnung in Auslenkungsrichtung) wird mit 60% bis 120% des Strokes, oder von 80% bis 100% gewählt. Die Biasspannung kann vorteilhaft im Bereich von 50% bis 200%, oder von 80% bis 150%, des für die Pixel individuellen Adressspannungsbereichs liegen. Der horizontale Elektrodenabstand von 50 % bis 150 % bzw. von 60 % bis 100 % des Strokes z_{S} ist dabei beispielsweise der mittlere oder durchschnittliche (d.h. wirksame oder effektive) horizontale (laterale) der ersten und zweiten Elektrodenstruktur in einer Ebene parallel zu einem Hauptoberflächenbereich des Substrats. Entsprechend ist die vertikale Dicke der ersten und zweiten Elektrodenstruktur dabei die mittlere oder durchschnittliche (d.h. wirksame oder effektive) Dicke der ersten und zweiten Elektrodenstruktur und beträgt beispielsweise 60 % bis 120 % oder 80 % bis 100 % des Strokes.

Basierend auf den obigen Designparametern für das MEMS-Aktuator-Element kann nun die für die jeweilige Anwendung gewünschte bzw. geforderte maximale Auslenkung z_{S} (Stroke) eingestellt werden, wobei für diese durch die Anwendung geforderte bzw. vorgegebene Größe der maximalen Auslenkung ein MEMS-Aktuator-Element mit für den jeweiligen Anwendungsfall optimierten (= minimalen) Abmessungen (Pitch), einer optimierten (= minimalen) Antriebsspannung, einer linearen Kennlinie und einem geringen Übersprechen zu benachbarten MEMS-Aktuator-Elementen erhalten werden kann.

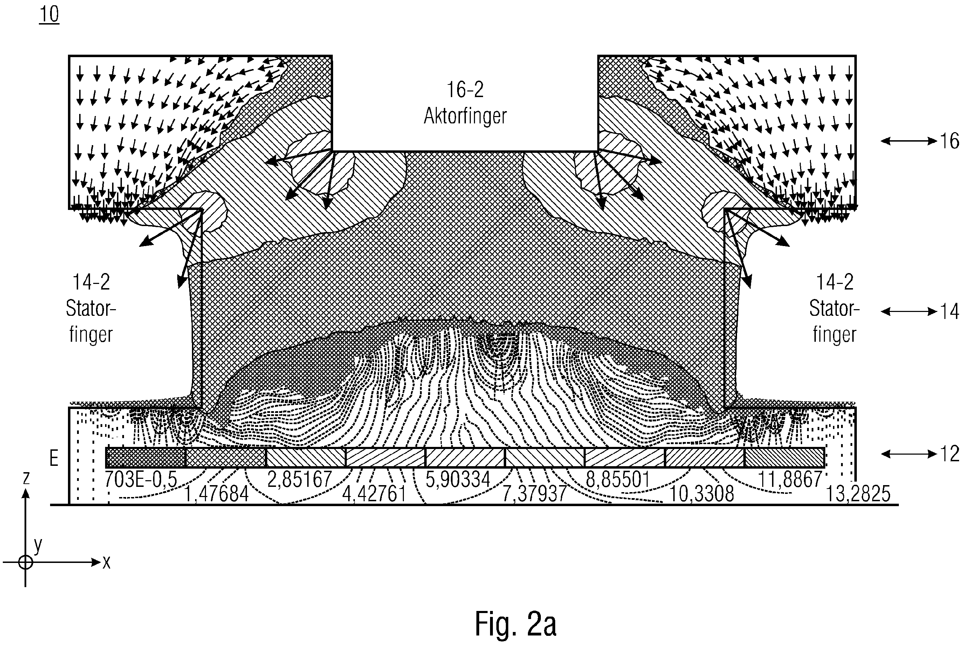

Fig. 2a zeigt die schematische Teilquerschnittsansicht von Fig.1b des MEMS-Aktuator-Elements 10 mit einer typischen resultierenden Konzentration des elektrischen Feldes E zwischen zwei Fingerelementen (Statorfingern) 14-2 der Kantenstruktur 14-1 der ersten Elektrodenstruktur (Stator) 14 und einem gegenüberliegenden Fingerelement (Aktorfinger) 16-2 der Kantenstruktur 16-1 der zweiten Elektrodenstruktur (Aktor) 16 des MEMS-Aktuator-Elements 10. Die schematische Teilquerschnittsansicht ist periodisch fortsetzbar, um die erste und zweite Elektrodenstruktur 14, 16 zu erhalten. Wie aus Fig. 2a zu entnehmen ist, befindet sich der Hauptanteil des elektrischen Feldes zwischen den Fingerelementen 14-2 und 16-2, so dass der Bereich hoher Feldstärken auf einen kleinen Raumbereich konzentriert ist. Die geringe Feldstärke des elektrischen Feldes im Außenraum ergibt ein geringes Übersprechen zu benachbarten MEMS-Aktuator-Elementen 10.

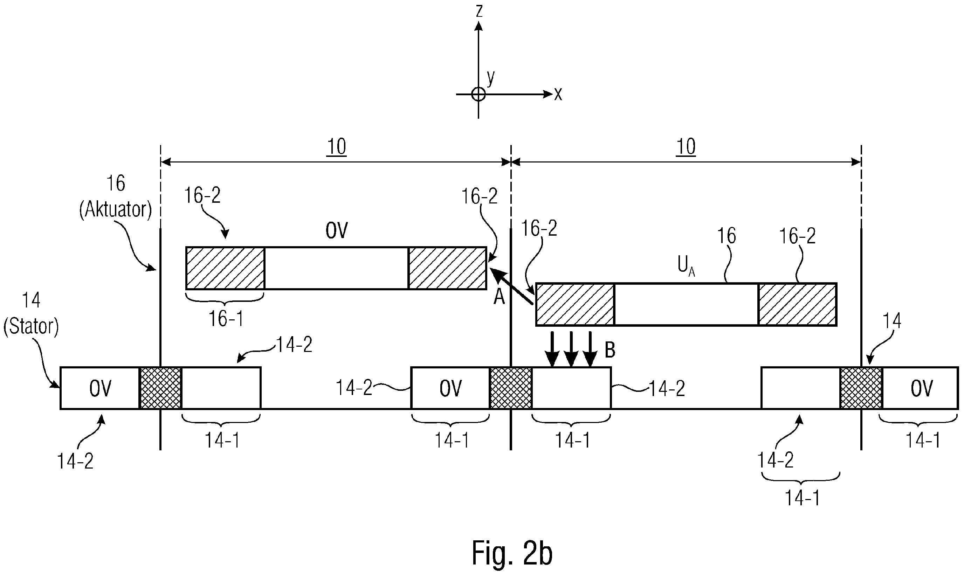

Fig. 2b zeigt die schematische Teilquerschnittsansicht von Fig.1b durch zwei benachbarte MEMS-Aktuator-Elemente 10 mit nur geringem Übersprechen (Pfeil A) durch großen Abstand zwischen den zweiten Elektrodenstrukturen 14 der benachbarten MEMS-Aktuator-Elemente 10, wobei sich der Hauptanteil des elektrischen Feldes (Pfeile B) zwischen den Fingerelementen 14-2 und 16-2 befindet.

Fig. 3 zeigt eine schematische, resultierende Kennlinie der Auslenkung z₁ zu Ansteuerspannung V_{S} eines MEMS-Aktuator-Elements 10 gemäß einem Ausführungsbeispiel.

So bewirkt eine Änderung der Ansteuerspannung Vs, mit Vs = V_{BIAS} + V_{BETRIEB}, in einen Spannungswert zwischen der minimalen Ansteuerspannung V_{S_MIN} und der maximalen Ansteuerspannung V_{S_MAX} eine entsprechende Änderung der Zwischenposition z₁ der Kantenstruktur 16-1 der zweiten Elektrodenstruktur 16 zwischen deren minimaler und maximaler Auslenkungsposition z_{MIN} und z_{MAX}.

In Fig. 3 sind rein beispielhafte Werte für die minimale Ansteuerspannung V_{S_MIN} und die maximale Ansteuerspannung V_{S_MAX} der Ansteuerspannung Vs sowie für die entsprechende Zwischenpositionen bzw. Auslenkungspositionen z₁ der Kantenstruktur 16-1 der zweiten Elektrodenstruktur 16 zwischen deren minimaler und maximaler Auslenkungsposition z_{MIN} und z_{MAX} angegeben.

Dabei sorgt der Überlapp in der Endlage (d.h. die vertikale Eintauchweg z_{E} der Kantenstruktur 16-1 der zweiten Elektrodenstruktur 16 bezüglich die Kantenstruktur 14-1 der ersten Elektrodenstruktur 14) für eine große maximale Aktuatorkraft zwischen der ersten und zweiten Elektrodenstruktur 14, 16, wobei der geringe Betrag des Überlappsz_{E} und der nicht zu kleine horizontale Abstand x₀ wiederum für moderate horizontale Kräfte zwischen der ersten und zweiten Elektrodenstruktur 14, 16 z.B. bei Fertigungsungenauigkeiten, sorgen. Die begrenzte Elektrodendicke d₁₄, d₁₆ der ersten und zweiten Elektrodenstruktur 14, 16 bewirkt, dass die Aktuatorkraft für eine gegebene Ansteuerspannung V_{S} bei zunehmender Auslenkung z₁ sogar wieder abnimmt, da die Aktuatorkraft in der theoretischen Symmetrielage (z_{E} = d₁₄) mit voll eingetauchten Elektrodenstrukturen 14, 16 notwendig Null ist, wobei die Kennlinie für große Ansteuerspannungen V_{S} damit nicht so steil wird wie in elektrostatischen Aktuatoren sonst üblich. Die theoretische Symmetrielage (mit z_{E} = d₁₄) wird aber gemäß Ausführungsbeispielen nicht erreicht, da gemäß Ausführungsbeispielen der vertikale Eintauchweg "z_{E}" (oder Überlapp) der Kantenstruktur 16-1 der zweiten Elektrodenstruktur 16 in die Kantenstruktur 14-1 der ersten Elektrodenstruktur 14 bis zu dem 0,5-fachen des maximalen Auslenkungswegs z_{S} beträgt, d.h. z_{E} ≤ 0,5 z_{S}. Damit wird eine Linearisierung der Auslenkungskennlinie (d.h. die Aktuatorposition bzw. -Auslenkung vs. Adressspannung) im Bereich großer Auslenkungen z₁ erreicht. Die Biasspannung V_{BIAS} schließlich sorgt für eine bessere Linearität im Bereich geringer Auslenkungen.

Wie in Fig. 3 beispielhaft dargestellt ist, kann die elektrische Ansteuerspannung V_{S} für den gewählten bzw. eingestellten maximalen Auslenkungsweg z_{S} (Stroke) in einem Bereich von etwa 4,5 bis 8,1 Volt liegen. Somit wird die minimale Ansteuerspannung V_{S_MIN} als eine Bias-Spannung V_{BIAS} von 4,5 V bereitgestellt. Somit weist die elektrische Ansteuerspannung V_{S} die Bias-Spannung V_{BIAS} und eine Betriebsspannung V_{BETRIEB} auf, wobei gemäß Fig. 3 beispielsweise der Betriebsspannungsbereich 3,6 Volt (V_{S_MAX}- V_{S_MIN} = 8,1 - 4,5 Volt) aufweist. Diese beispielhaften Werte können je nach Anwendungsfall und resultierenden Abmessungen des MEMS-Aktuator-Elements 10 beispielsweise um einen Faktor von 0,3 bis 3, von 0,5 bis 2 oder von 0,8 bis 1,2 variieren.

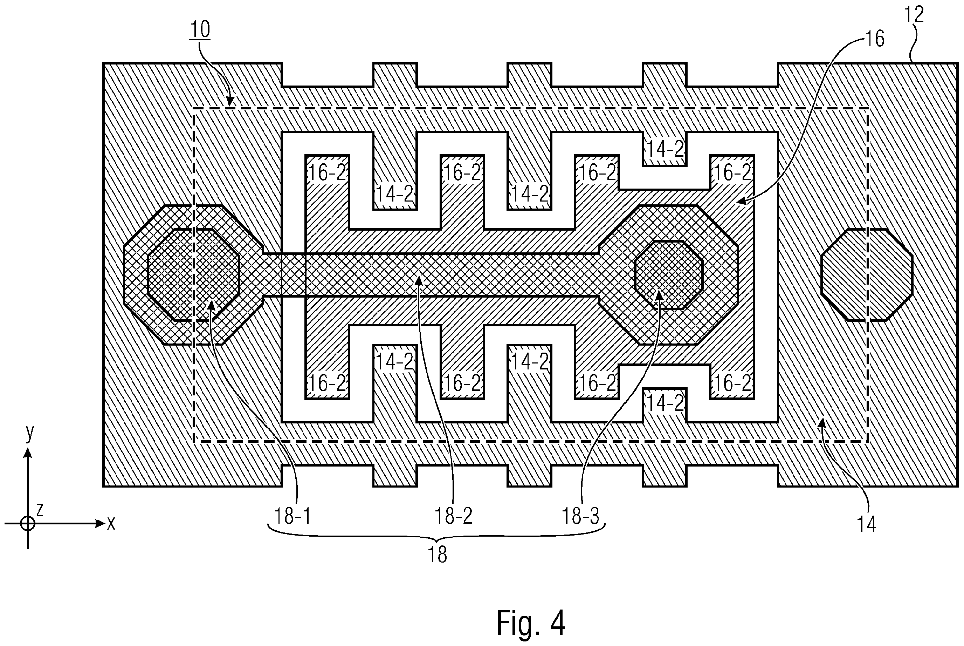

Fig. 4 zeigt eine schematische Draufsicht eines rechteckigen MEMS-Aktuator-Elements, z.B. eine Einheitszelle für ein Array, mit einem einseitig eingespannten Federelement 18-2 (Cantilever) der Federstruktur 18 gemäß einem Ausführungsbeispiel.

Gemäß dem Ausführungsbeispiel von Fig. 4 kann das Verbindungselement 18-3 an einem vom Flächenschwerpunkt unterschiedlichen Verbindungsbereich mit dem Funktionselement 20 mechanisch gekoppelt sein, wobei das Verbindungselement 18-3 ferner mit der zweiten Elektrodenstruktur 16 mechanisch gekoppelt ist. Diese unsymmetrische Anordnung ist aber nur als beispielhaft anzusehen.

In diesem Zusammenhang wird nochmals darauf hingewiesen, dass der Begriff "Kammantrieb" (comb drive) hier (gerade mit Hinblick auf sehr kleine Pixel 10) sehr allgemein verstanden werden soll, da auch Elektrodenstrukturen 14, 16 mit nur wenigen Fingerelementen 14-2, 16-2 oder auch Elektrodenstrukturen 14, 16 ganz ohne Fingerelemente nach den gleichen Grundlagen funktionieren.

So können gemäß dem vorliegenden Funktionsprinzip die erste und/oder zweite Elektrodenstruktur 14, 16 als Kantenelemente ohne Finger- oder Kammelemente eingesetzt werden, wobei die erste und zweite Elektrodenstruktur 14, 16 gleichermaßen nach den hier beschriebenen Grundlagen funktionieren. So kann beispielsweise die erste Elektrodenstruktur 14 in einer Draufsicht (parallel zur x-y-Ebene) als eine umlaufende Struktur zu der zweiten Elektrodenstruktur 16 ausgebildet sein. Allgemein kann dann auch von einem elektrostatischen Kantenaktuator-Element gesprochen werden, da die Aktuatorkraft proportional zu der Länge der sich gegenüberstehenden Kantenstrukturen 14-1, 16-1 der ersten und zweiten Elektrodenstruktur 14, 16 ist.

Das Vorsehen von Fingerelementen 14-2, 16-2 kann weitere Vorteil bereitstellen, soweit es die herstellbaren (minimalen) Strukturgrößen erlauben.

Fig. 4 zeigt ein Beispiel für ein derartiges MEMS-Aktuator-Element 10 mit nur wenigen Fingerelementen 14-2, 16-2, die sich in der Substratebene oder parallel zu der Substratebene dicht anordnen lassen und Abmessungen für das MEMS-Aktuator-Element 10 (= Pixelgrö-ßen) von nur rund dem rund acht- bis sechzehnfachen der Minimalstrukturgröße aufweisen können.

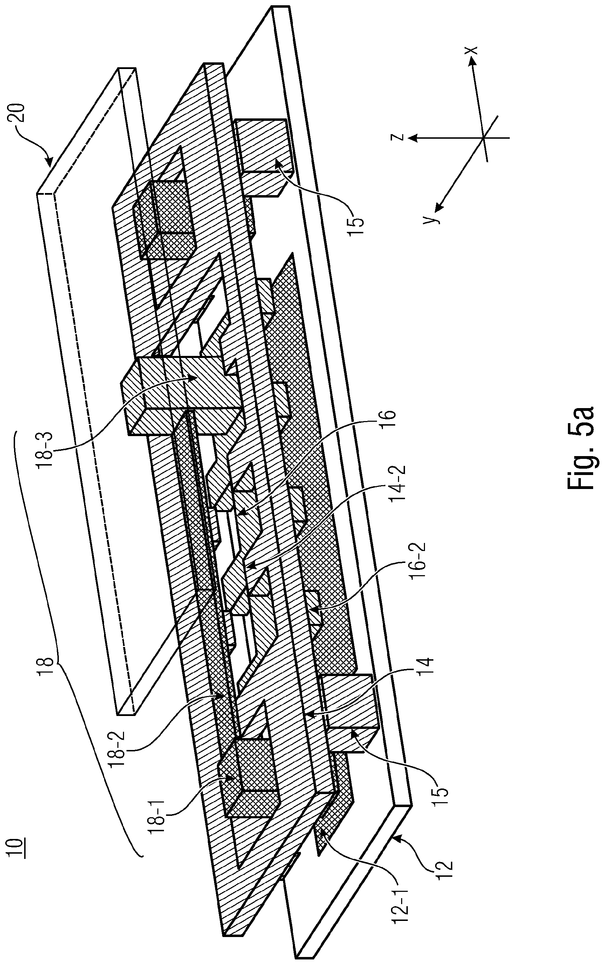

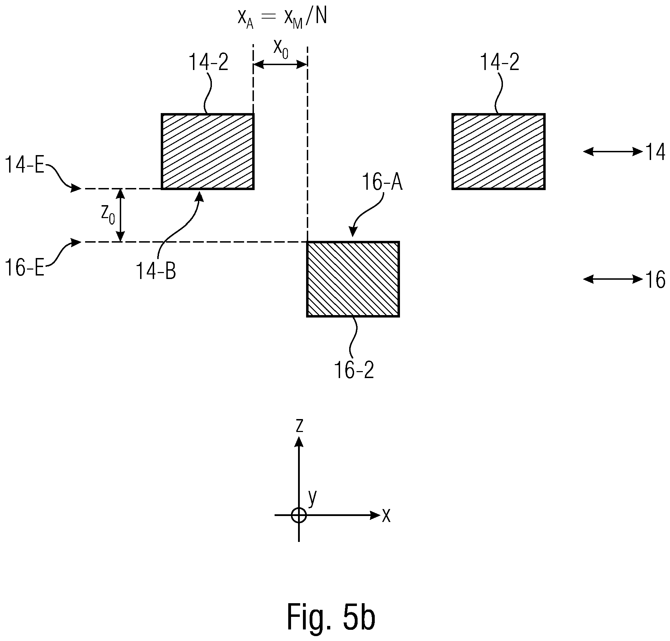

Fig. 5a zeigt eine schematische perspektivische Ansicht eines MEMS-Aktuator-Elements 10 gemäß einem weiteren Ausführungsbeispiel. Fig. 5b zeigt eine schematische Teilquerschnittsansicht durch zwei Fingerelemente 14-2 der ersten Elektrodenstruktur 14 und ein gegenüberliegendes Fingerelement 16-2 der zweiten Elektrodenstruktur 16 gemäß einem Ausführungsbeispiel.

Das MEMS-Aktuator-Element 10 umfasst wieder die erste Elektrodenstruktur 14 mit einer Kantenstruktur 14-1, wobei die erste Elektrodenstruktur 14 mit der Kantenstruktur 14-1 bezüglich des Substrats 12 feststehend angeordnet ist. Die erste Elektrodenstruktur 14 mit der Kantenstruktur 14-1 ist mittels Abstandselementen 15 beabstandet von dem Hauptoberflächenbereich 12-A des Substrats 12 angeordnet. Die Abstandselemente (Spacer) 15 können Teil der ersten Elektrodenstruktur 14 und/oder des Substrats 12 sein.

Das MEMS-Aktuator-Element 10 weist eine oben-liegende ersten Elektrodenstruktur (Stator) 14 mit den Fingerelementen (Statorfingern) 14-2 der Kantenstruktur 14-1 auf, wobei die zweite Elektrodenstruktur (Aktor) 16 mit den Fingerelement (Aktorfinger) 16-2 der Kantenstruktur 16-1 (in der Ruheposition z_{MIN}) vertikal zwischen der ersten Elektrodenstruktur 14 und dem Substrat 12 angeordnet ist.

Der laterale Abstand x₀ bezieht sich (in einer Draufsicht) wieder auf lateral gegenüberliegende Abschnitte der Kantenstrukturen 14-1, 16-1 der ersten und zweiten Elektrodenstruktur 14, 16, während sich der vertikale Abstand z₀ auf vertikal versetzte, gegenüberliegende Randebenen 14-E, 16-E der Kantenstrukturen 14-1, 16-1 der ersten und zweiten Elektrodenstruktur 14, 16 bezieht. Dabei erstreckt sich die Randebene 14-E der ersten Elektrodenstruktur 14 entlang des unteren Hauptoberflächenbereichs 14-B der ersten Elektrodenstruktur 14, wobei sich die Randebene 16-E der zweiten Elektrodenstruktur 16 entlang des oberen Hauptoberflächenbereichs 16-A der zweiten Elektrodenstruktur 16 erstreckt.

Das MEMS-Aktuator-Element 10 kann ferner eine leitfähige Grundplatte 12-1 zur Abschirmung des Einflusses der darunter liegenden Elektronik (nicht gezeigt) aufweisen. Die leitfähige Grundplatte 12-1 kann als Teil des Substrats 12 ausgebildet sein. Anders als in den obigen Ausführungsbeispielen kann es vorteilhaft sein, die feste Elektrodenstruktur 14 (den Stator) vertikal oberhalb der beweglichen Elektrodenstruktur 16 anzuordnen, also auf der dem Substrat 12 abgewandten Seite wie dies in Fig. 5a dargestellt ist.

Fig. 5a zeigt somit ein weiteres Beispiel für ein MEMS-Aktuator-Element 10 mit nur wenigen Fingerelementen 14-2, 16-2, die sich in der Substratebene oder parallel zu der Substratebene dicht anordnen lassen und Abmessungen für das MEMS-Aktuator-Element 10 (= Pixelgrößen) von nur rund dem rund acht- bis sechzehnfachen der Minimalstrukturgröße aufweisen können.

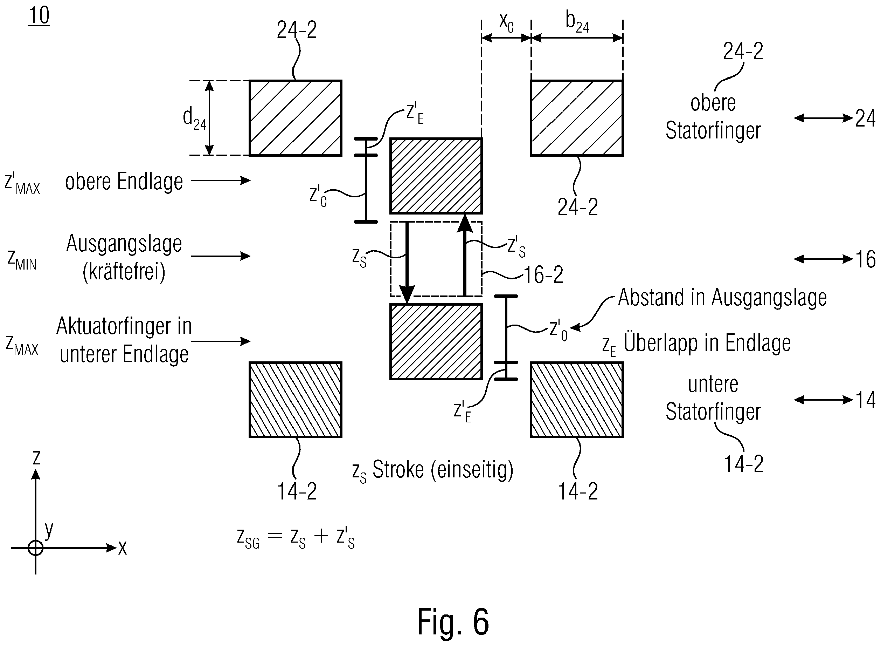

Fig. 6 zeigt eine schematische partielle Querschnittsansicht durch einen Teil bzw. durch einige Fingerelemente eines MEMS-Aktuator-Elements 10 gemäß einem Ausführungsbeispiel, wobei das MEMS-Aktuator-Element 10 als ein doppelt wirkender Aktuator ausgebildet ist.

Gemäß einem Ausführungsbeispiel kann das MEMS-Aktuator-Element 10 eine dritte Elektrodenstruktur 24 aufweisen, die bezüglich des Substrats 12 feststehend angeordnet ist, wobei die zweite Elektrodenstruktur 16 (z.B. symmetrisch) zwischen der ersten und dritten Elektrodenstruktur 14, 24 angeordnet und auslenkbar ist. Dabei ist die zweite Elektrodenstruktur 16 mittels der ersten und dritten Elektrodenstruktur 14, 24 elektrostatisch von der minimalen Auslenkungsposition (= Ruheposition) z_{MIN} in eine vertikal beabstandete, weitere maximale Auslenkungsposition (= ober maximale Auslenkungsposition) z_{MAX'} bewegbar.

So sind in Fig. 6 zwei einzelne Fingerelemente 14-2 der Kantenstruktur 14-1 der ersten Elektrodenstruktur 14 und zwei einzelne Fingerelemente 24-2 der Kantenstruktur 24-1 der dritten Elektrodenstruktur 24 sowie ein sich relativ dazu bewegendes Fingerelement 16-2 der Kantenstruktur 16-1 der zweiten Elektrodenstruktur 16 dargestellt. Die in Fig. 6 dargestellte Anordnung aus Fingerelementen 14-2, 16-2, 24-2 der Kantenstrukturen 14-1, 16-1, 24-1 ist (zumindest abschnittsweise) periodisch fortsetzbar, um die umlaufenden Kantenstrukturen 14-1, 16-1, 24-1 der ersten, zweiten und dritten Elektrodenstruktur 14, 16, 24 zu bilden.

Bezüglich der geometrischen Anordnung der ersten und zweiten Elektrodenstruktur 14, 16 wird auf die Ausführungen zu Fig. 1b verwiesen, die hier gleichermaßen anwendbar sind.

Wie in Fig. 6 beispielhaft dargestellt ist, weisen die Fingerelemente 14-2 der ersten Elektrodenstruktur 14 wieder eine vertikale Dicke d₁₄ (in z-Richtung) und eine laterale Breite b₁₄ auf. Das Fingerelement 16-2 der zweiten Elektrodenstruktur 16 weist eine vertikale Dicke d₁₆ und eine laterale (horizontale) Breite b₁₆ auf. Die Fingerelemente 24-2 der dritten Elektrodenstruktur 24 eine vertikale Dicke d₂₄ (in z-Richtung) und eine laterale Breite b₂₄ auf. Gemäß einem Ausführungsbeispiel kann optional gelten d₁₂ = d₁₄ = d₂₄ und b₁₂ = b₁₄ = b₂₄, wobei aber auch andere geometrische Größenverhältnisse gewählt werden können.

Die gestrichelte Darstellung des Fingerelements 16-2 gibt beispielsweise eine minimale Auslenkungsposition (Grundposition oder Ausgangslage) z_{MIN} der zweiten Elektrodenstruktur 16 wieder, während die durchgehend gezeichnete (vertikal) untere Fingerstruktur 16-2 der zweiten Elektrodenstruktur 16 die maximale Auslenkposition z_{MAX} (= untere Endlage) der zweiten Elektrodenstruktur 16 darstellt und die weitere durchgehend gezeichnete (vertikal) obere Fingerstruktur 16-2 der zweiten Elektrodenstruktur 16 die weitere maximale Auslenkposition z'_{MAX} (= obere Endlage) der zweiten Elektrodenstruktur 16 darstellt.

In der minimalen Auslenkposition z_{MIN} sind die Kantenstrukturen 16-1, 24-1 der zweiten und dritten Elektrodenstruktur 16, 24 vertikal (= parallel zur z-Richtung) in einem Abstand z'₀ voneinander beabstandet sind, wobei in der weiteren maximalen Auslenkposition z'_{MAX} das Fingerelement 16-2 der zweiten Elektrodenstruktur 16 vertikal zwischen die beiden Fingerelemente 24-2 der dritten Elektrodenstruktur "eingetaucht" ist. Bei dem MEMS-Aktuator-Element 10 beträgt in der weiteren maximalen Auslenkposition z'_{MAX} der vertikale Eintauchweg z'_{E} (oder Überlapp) der Kantenstruktur 16-1 der zweiten Elektrodenstruktur 16 in die Kantenstruktur 24-1 der dritten Elektrodenstruktur 14 bis zu dem 0,5-fachen des maximalen Auslenkungswegs z's, d.h. z'_{E} ≤ 0,5 z'_{S}. Die Wegstrecke zwischen der Ruheposition z_{MIN} und der weiteren maximalen Eintauchposition z'_{MAX} wird als weiterer maximaler Auslenkungsweg bzw. Stroke z's bezeichnet, und erstreckt sich entlang der Auslenkungspositionen bzw. Auslenkungszwischenpositionen z₁. Bei dem MEMS-Aktuator-Element 10 sind die Kantenstrukturen 16-1, 24-1 der zweiten und dritten Elektrodenstruktur 16, 24 hinsichtlich einer Draufsicht in einem lateralen Abstand x₀ gegenüberstehend ausgebildet.

Die Wegstrecke zwischen der Ruheposition z_{MIN} und der maximalen Eintauchposition z_{MAX}, d.h. der maximale Auslenkungsweg bzw. Stroke z_{S}, und die Wegstrecke zwischen der Ruheposition z_{MIN} und der weiteren maximalen Eintauchposition z'_{MAX}, d.h. der weitere maximale Auslenkungsweg bzw. Stroke z'_{S}, addieren sich somit zu dem Gesamt-Stroke z_{SG} (mit z_{SG} = z_{S} + z'_{S}).

Gemäß einem Ausführungsbeispiel können der maximale Auslenkungsweg z_{S} und der weitere maximale Auslenkungsweg z's (innerhalb eines Toleranzbereichs von ≤ 5% oder 10%) gleich sein, wobei kleinere Abweichungen und Toleranzen zwischen z_{S} und z's das beschriebene Funktionsprinzip der MEMS-Aktuator-Elements 10 nicht beeinträchtigen.

Gemäß einem Ausführungsbeispiel sind also die zweite und dritte Elektrodenstruktur 16, 24 ausgebildet, um basierend auf einer weiteren elektrischen Ansteuerspannung V'_{S} die zweite Elektrodenstruktur 16 in die weitere Zwischenposition z'₁ zwischen der minimalen Auslenkungsposition z_{MIN} und der weiteren maximalen Auslenkungsposition z'_{MAX} elektrostatisch auszulenken. Dabei bewirkt ein Minimalwert der Ansteuerspannung V'_{S} eine Positionierung oder Auslenkung der Kantenstruktur 16-1 der zweiten Elektrodenstruktur 16 in die minimale Auslenkungsposition z_{MIN} und ein weiterer Maximalwert der Ansteuerspannung V's eine Auslenkung der Kantenstruktur 16-1 der zweiten Elektrodenstruktur 16 in die weitere maximale Auslenkungsposition z'_{MAX}. Der weitere Ansteuerspannungsbereich (= Adressspannungsbereich) liegt zwischen der minimalen Wert V_{_MIN} der Ansteuerspannung V'_{S} und dem weiteren maximalen Wert V'_{_MAX} der Ansteuerspannung V'_{S}.

Ferner bewirkt eine Änderung der Ansteuerspannung V'_{S} in einen Spannungswert zwischen der minimalen Ansteuerspannung V_{S_MIN} und der weiteren maximalen Ansteuerspannung V'_{S_MAX} eine entsprechende Änderung der weiteren Zwischenposition z'₁ der Kantenstruktur 16-1 der zweiten Elektrodenstruktur 16 zwischen deren minimaler Auslenkungsposition z_{MIN} und der weiteren maximaler Auslenkungsposition z'_{MAX}.

Gemäß einem Ausführungsbeispiel kann das MEMS-Aktuator-Element 10 ferner die Ansteuereinrichtung 22 zum Bereitstellen der weiteren Ansteuerspannung V's zwischen der zweiten und dritten Elektrodenstruktur 16, 24 aufweisen. Gemäß einem Ausführungsbeispiel kann die weitere Ansteuerspannung V'_{S} einen Vorspannungsanteil (eine Biasspannung) V_{BIAS} und einen weiteren Betriebsspannungsanteil V'_{BETRIEB} aufweisen.

Gemäß einem Ausführungsbeispiel kann das MEMS-Aktuator-Element 10 ausgelegt sein, so dass in der weiteren maximalen Auslenkungsposition z'_{MAX} der weitere vertikale Eintauchweg z'_{E} der Kantenstruktur 16-1 der zweiten Elektrodenstruktur 16 bezüglich der Kantenstruktur 24-1 der dritten Elektrodenstruktur 24 bis zu dem 0,5-fachen des weiteren maximalen Auslenkungswegs z'_{S}, d.h. z'_{E} ≤ 0,5 z's beträgt. Gemäß einem Ausführungsbeispiel kann der weitere vertikale Eintauchweg z'_{E} ferner zwischen dem 0,1- und 0,4-fachen oder zwischen dem 0,2- und dem 0,3-fachen des weiteren maximalen Auslenkungswegs z's betragen.

Gemäß einem Ausführungsbeispiel kann das MEMS-Aktuator-Element 10 ferner ausgelegt sein, so dass die zweite und dritte Elektrodenstruktur 16, 24 in einer Ebene parallel zu dem Substrat 12 um einen lateralen Mindestabstand x₀ beabstandet sind, wobei der laterale Mindestabstand x₀ das 0,5- bis 1,5-fache oder das 0,6- bis 1-fache des weiteren maximalen Auslenkungswegs z'_{S} beträgt.

Gemäß einem Ausführungsbeispiel kann das MEMS-Aktuator-Element 10 ferner ausgelegt sein, so dass die vertikale Dicke d24 der dritten Elektrodenstruktur 24 das 0,6- bis 1,2-fache oder das 0,8- bis 1,0-fache des weiteren maximalen Auslenkungswegs z'_{S} beträgt.

Gemäß einem Ausführungsbeispiel kann das MEMS-Aktuator-Element 10 ferner ausgelegt sein, so dass die minimale Ansteuerspannung als eine Biasspannung U_{BIAS} bereitgestellt wird, wobei die weitere elektrische Ansteuerspannung V'_{S} die Biasspannung U_{BIAS} und die weitere Betriebsspannung (Adressspannung) V'_{BETRIEB} aufweist, wobei die Biasspannung V_{BIAS} in einem Bereich zwischen dem 0,5-fachen bis 2-fachen oder dem 0,8-fachen bis 1,5-fachen des weiteren Betriebsspannungsbereichs liegen kann.

Bei Kammantrieben bzw. Kantenantrieben gemäß den beschriebenen Ausführungsbeispielen kann das elektrostatische Feld durch den relativ geringen Elektrodenabstand räumlich eng im Bereich der Elektrodenfinger 14-2, 16-2, 24-2 begrenzt werden. Dadurch können relative hohe Aktuatorkräfte selbst bei der fertigungsbedingten Minimalgröße der Elektrodenstrukturen 14, 16, 24 mit nur einigen wenigen Fingerelementen 14-2, 16-2, 24-2 erreicht werden. Dazu erlaubt der beschriebene Kamm- bzw. Kantenantrieb ein geringes Übersprechen zwischen benachbarten Aktuatoren 10.

Gemäß einem Ausführungsbeispiel kann die Elektrodenstruktur 14 oder 16 mit dem gemeinsamen Potenzial U_{BIAS} aller Pixel bzw. Aktuatoren 10 an dem Rand des Pixels 10 liegen. Wenn dies die feste Elektrodenstruktur 14 ist, kann diese direkt mit der festen Elektrodenstruktur 14, 24 des Nachbarpixels (nicht gezeigt in Fig. 6) verbunden werden, wodurch ein sehr niedriger Platzbedarf erhalten wird.

Die obigen Ausführungen zu dem MEMS-Aktuator-Element 10 von Fig. 6 machen somit deutlich, dass das vorliegende Konzept auch bei doppelt wirkenden Aktuatoren vorteilhaft eingesetzt werden kann, bei denen der beweglichen Elektrodenstruktur 16 in beiden Richtungen (also 'oberhalb' und 'unterhalb') feste Elektrodenstrukturen 14, 24 gegenüber stehen. Dadurch muss jede Elektrodenstruktur 14, 24 nur für den halben Gesamt-Stroke z_{SG} dimensioniert werden, was die maximale Aktuatorkraft und die Linearität nochmals stark verbessern kann. Dies kann den zusätzlichen Aufwand für die aufwändigere Fertigung des MEMS-Aktuator-Elements 10 von Fig. 6 aufwiegen. Alternativ können auch hier (wie bei allen Ausführungsbeispielen) die Rollen bzw. Funktionen von festen und beweglichen Elektrodenstrukturen 14, 16 grundsätzlich umgekehrt werden.

Wie bereits im Vorhergehenden angegeben wurde, kann das MEMS-Aktuator-Element 10 gemäß Ausführungsbeispielen ausgebildet sein, dass die zweite Elektrodenstruktur 16 translatorisch oder rotatorisch (= kippend oder drehend) bezüglich der ersten Elektrodenstruktur 14 auslenkbar ist, dass die zweite Elektrodenstruktur 16 translatorisch und rotatorisch bezüglich der ersten Elektrodenstruktur 14 auslenkbar ist, dass die zweite Elektrodenstruktur 16 translatorisch oder rotatorisch bezüglich der ersten und dritten Elektrodenstruktur 14, 24 auslenkbar ist, oder dass die zweite Elektrodenstruktur 16 translatorisch und rotatorisch bezüglich der ersten und dritten Elektrodenstruktur 14, 24 auslenkbar ist.

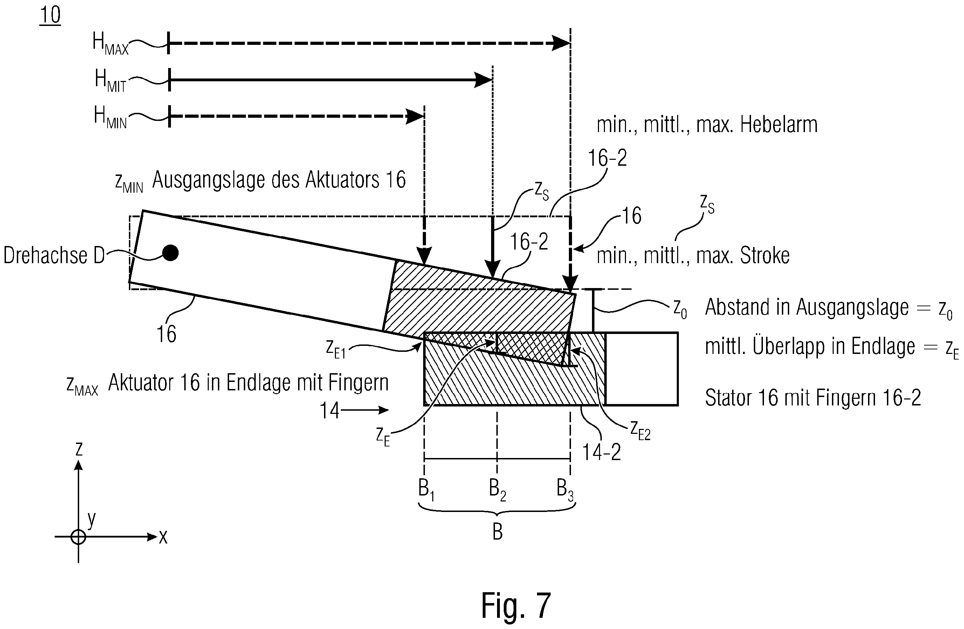

Fig. 7 zeigt nun eine schematische Querschnittsansicht senkrecht zu einer Kipp- oder Drehachse D durch einen Teil eines MEMS-Aktuator-Elements 10 gemäß einem Ausführungsbeispiel, wobei das MEMS-Aktuator-Element 10 als ein Kipp-Aktuator (auch Dreh-Aktuator) ausgebildet ist;

Auch wenn im Vorhergehenden verschiedene Ausführungsbeispiele und die Wortwahl der Beschreibung sich auf translatorischen MEMS-Aktuator-Elemente 10, z.B. mit parallel auslenkenden Mikrospiegel (Senkspiegel), beziehen, ist das vorliegende erfindungsgemäße Konzept auch für andere MEMS-Elemente geeignet, speziell auch MEMS-Aktuator-Elemente 10 ohne Spiegel.

Auch rotatorische MEMS-Aktuator-Element 10 (Aktuatoren) können auf diese Weise optimiert werden, wobei der für die translatorischen MEMS-Aktuator-Elemente 10, die z.B. Senkspiegel aufweisen können, definierte Stroke z_{S} dann durch die mit dem Abstand von der Drehachse gewichtete mittlere Auslenkung der Kantenstruktur(en) des rotatorischen MEMS-Aktuator-Elements 10 ersetzt werden kann.

Das MEMS-Aktuator-Element 10 umfasst ferner die erste Elektrodenstruktur 14 mit der Kantenstruktur 14-1 bzw. den Fingerelementen 14-2, wobei die erste Elektrodenstruktur 14 bezüglich des Substrats 12 feststehend angeordnet ist. Die erste Elektrodenstruktur 14 kann beispielsweise direkt an oder auch beabstandet von dem Hauptoberflächenbereich 12-A des Substrats 12 feststehend angeordnet sein.

Das MEMS-Aktuator-Element 10 umfasst ferner eine zweite Elektrodenstruktur 16 mit einer Kantenstruktur 16-1 bzw. Fingerelementen 16-2, wobei die zweite Elektrodenstruktur 16 mittels einer Federstruktur 18 (nicht gezeigt in Fig. 7) auslenkbar mit dem Substrat 12 gekoppelt ist und mittels der ersten Elektrodenstruktur 14 elektrostatisch auslenkbar ist, um die Fingerelemente 16-2 der zweiten Elektrodenstruktur 16 mittels einer Kipp- oder Drehbewegung um eine Drehachse D in eine Zwischenposition bzw. Auslenkungsposition z₁ zwischen einer minimalen Auslenkungsposition z_{MIN} und einer vertikal beabstandeten maximalen Auslenkungsposition z_{MAX} zu bewegen, wobei die minimale und maximale Auslenkungsposition z_{MIN}, z_{MAX} einen maximalen Auslenkungsweg bzw. Stroke z_{S} vorgeben.

Bei dem MEMS-Aktuator-Element 10 sind die Kantenstrukturen 14-1, 16-1 der ersten und zweiten Elektrodenstruktur 14, 16 hinsichtlich einer Draufsicht, z.B. in einem lateralen Abstand x₀, gegenüberstehend ausgebildet und in der minimalen Auslenkposition z_{MIN} vertikal, z.B. in einem vertikalen Abstand z₀, voneinander beabstandet sind. Bezüglich der geometrischen Abmessungen der ersten und zweiten Elektrodenstruktur 14, 16 wird auf die Ausführungen zu Fig. 1b verwiesen, die hier gleichermaßen anwendbar sind. In der minimalen Auslenkposition z_{MIN} bezieht sich der laterale Abstand x₀ (in einer Draufsicht) auf lateral gegenüberliegende Abschnitte der Kantenstrukturen 14-1, 16-1 der ersten und zweiten Elektrodenstruktur 14, 16, während sich der vertikale Abstand z₀ auf vertikal versetzte, gegenüberliegende Ebenen der Kantenstrukturen 14-1, 16-1 der ersten und zweiten Elektrodenstruktur 14, 16 bezieht.

Die Federstruktur (nicht gezeigt in Fig. 7) kann beispielsweise als eine Torsionsfeder ausgebildet sein. Ausführungsbeispiele beziehen sich somit wieder auf MEMS-Aktuator-Elemente 10, die elektrostatisch z.B. mit einer Biasspannung angesteuert werden und über eine rückstellende elastische Aufhängung verfügen, die für eine statische Gleichgewichts-Auslenkung eine entsprechende Gegenkraft aufbringt, um die zweite Elektrodenstruktur 16 in die minimale Auslenkposition z_{MIN} zu bringen.

Wie in Fig. 7 beispielhaft dargestellt ist, können die Fingerelemente 16-2 der zweiten Elektrodenstruktur 16 hinsichtlich einer Draufsicht (und parallel zu der x-y-Ebene) ineinandergreifend zu den Fingerelementen 14-2 der ersten Elektrodenstruktur 14 ausgebildet sein. So kann die Kantenstruktur 14-1 der ersten Elektrodenstruktur 14 eine Finger- oder Kammstruktur aufweisen, wobei die Kantenstruktur 16-1 der zweiten Elektrodenstruktur 16 eine weitere gegenüberliegende Finger- oder Kammstruktur aufweisen kann.

In diesem Fall wird beispielsweise auch von einem "Kammantrieb" (engl. comb drive), der durch die erste und zweite Elektrodenstruktur 14, 16 gebildet ist, gesprochen. In diesem Zusammenhang wird aber darauf hingewiesen, dass der Begriff "Kammantrieb" nicht einschränkend zu verstehen ist, da auch für die erste und/oder zweite Elektrodenstruktur 14, 16 auch nur mit wenigen Finger- oder Kammelementen 14-2, 16-2 eingesetzt werden können. Ferner können gemäß dem vorliegenden Funktionsprinzip die erste und/oder zweite Elektrodenstruktur 14, 16 als Kantenelemente ohne Finger- oder Kammelemente eingesetzt werden, wobei die erste und zweite Elektrodenstruktur 14, 16 gleichermaßen nach den hier beschriebenen Grundlagen funktionieren. So kann beispielsweise die erste Elektrodenstruktur 14 in einer Draufsicht (parallel zur x-y-Ebene) als eine umlaufende Kantenstruktur 14-1 zu der zweiten Elektrodenstruktur 16 ausgebildet sein. Allgemein kann dann auch von einem elektrostatischen Kantenaktuator-Element gesprochen werden, da die Aktuatorkraft proportional zu der Länge der sich gegenüberstehenden Kantenstrukturen 14-1, 16-1 der ersten und zweiten Elektrodenstruktur 14, 16 ist.

So sind in Fig. 7 ein Fingerelement 14-2 der Kantenstruktur 14-1 der ersten Elektrodenstruktur 14 und ein sich relativ dazu bewegendes Fingerelement 16-2 der Kantenstruktur 16-1 der zweiten Elektrodenstruktur 16 dargestellt. Die in Fig. 7 dargestellte Anordnung aus Fingerelementen 14-2, 16-2 der Kantenstrukturen 14-1, 16-1 ist (zumindest abschnittsweise) periodisch fortsetzbar, um die Kantenstrukturen 14-1, 16-1 der ersten und zweiten Elektrodenstruktur 14, 16 zu bilden.

Wie in Fig. 7 beispielhaft dargestellt ist, gibt die gestrichelte Darstellung der zweite Elektrodenstruktur 16 beispielsweise eine minimale Auslenkungsposition (Grundposition) z_{MIN} der zweiten Elektrodenstruktur 16 wieder, während der durchgehend gezeichnete Umriss der zweiten Elektrodenstruktur 16 die maximale Auslenkposition z_{MAX} der zweiten Elektrodenstruktur 16 darstellt.

In der minimalen Auslenkposition z_{MIN} sind die Kantenstrukturen 14-1, 16-1 der ersten und zweiten Elektrodenstruktur 14, 16 vertikal (= parallel zur z-Richtung) in einem Abstand z₀ voneinander beabstandet sind, wobei in der maximalen Auslenkposition z_{MAX} das Fingerelement 16-2 der zweiten Elektrodenstruktur 16 vertikal zwischen zwei Fingerelemente 14-2 der ersten Elektrodenstruktur "eingetaucht" ist.

Wie in Fig. 7 dargestellt ist, ergibt sich ein lateraler Fingerüberdeckungsbereich B der ersten und zweiten Elektrodenstruktur 16, in dem die Fingerelemente 14-2, 16-2 der ersten und zweiten Elektrodenstruktur 16 in einer Draufsicht (d.h. parallel zur x-y-Ebene) ineinandergreifen und sich parallel erstrecken. Der laterale Fingerüberdeckungsbereich B weist einen Anfangspunkt B1 (= Anfang der Kantenstruktur 14-1 bzw. des Fingerelements 14-2 der ersten Elektrodenstruktur 14), einen Mittenpunkt B2 (= Mittenposition zwischen dem Ende der Kantenstruktur 14-1 bzw. dem Ende des Fingerelements 14-2 der ersten Elektrodenstruktur 14 und dem Ende der Kantenstruktur 16-1 bzw. dem Ende des Fingerelements 16-2 der zweiten Elektrodenstruktur 16) und einen Endpunkt B3 (= Ende der Kantenstruktur 16-1 bzw. des Fingerelements 16-2 der zweiten Elektrodenstruktur 16) auf.

Ein minimaler Hebelarm H_{MIN} der zweiten Elektrodenstruktur 16 erstreckt sich ausgehend von Drehachse D der zweiten Elektrodenstruktur 16 bis zu dem Anfangspunkt B1 des lateralen Fingerüberdeckungsbereichs B. Ein mittlerer Hebelarm H_{MIT} der zweiten Elektrodenstruktur 16 erstreckt sich ausgehend von Drehachse D der zweiten Elektrodenstruktur 16 bis zu dem Mittenpunkt B2 des lateralen Fingerüberdeckungsbereichs B. Ein maximaler Hebelarm H_{MAX} der zweiten Elektrodenstruktur 16 erstreckt sich ausgehend von Drehachse D der zweiten Elektrodenstruktur 16 bis zu dem Anfangspunkt B1 des lateralen Fingerüberdeckungsbereichs B.

So ergibt sich in der maximalen Auslenkposition z_{MAX} ein minimaler vertikaler Eintauchweg z_{E1} am dem Anfangspunkt B1 des lateralen Fingerüberdeckungsbereichs B, ein mittlerer vertikaler Eintauchweg z_{E} an dem Mittenpunkt B2 des lateralen Fingerüberdeckungsbereichs B, und ein maximaler vertikaler Eintauchweg z_{E2} am dem Endpunkt B3 des lateralen Fingerüberdeckungsbereichs B.

Gemäß einem Ausführungsbeispiel entspricht der mittlere vertikale Eintauchweg z_{E} von Fig. 7 dem vertikalen Eintauchweg "z_{E}" (oder Überlapp bzw. vertikaler Überlapp) der Kantenstruktur 16-1 der zweiten Elektrodenstruktur 16 in die Kantenstruktur 14-1 der ersten Elektrodenstruktur 14 gemäß den vorherigen Ausführungsbeispielen.

Gemäß einem Ausführungsbeispiel entspricht ferner der "mittlere" Auslenkungsweg z_{S} an dem Mittenpunkt B2 des lateralen Fingerüberdeckungsbereichs B dem maximalen Auslenkungsweg bzw. Stroke z_{S} der Kantenstruktur 16-1 der zweiten Elektrodenstruktur 16 in die Kantenstruktur 14-1 der ersten Elektrodenstruktur 14 gemäß den vorherigen Ausführungsbeispielen.

Bei dem MEMS-Aktuator-Element 10 beträgt in der maximalen Auslenkposition z_{MAX} der vertikale Eintauchweg "z_{E}" (oder Überlapp) der Kantenstruktur 16-1 der zweiten Elektrodenstruktur 16 in die Kantenstruktur 14-1 der ersten Elektrodenstruktur 14 bis zu dem 0,5-fachen des maximalen Auslenkungswegs z_{S}, d.h. z_{E} ≤ 0,5 z_{S}. Die Wegstrecke zwischen der minimalen Auslenkungsposition z_{MIN} und der maximalen Eintauchposition z_{MAX} wird als maximaler Auslenkungsweg bzw. Stroke z_{S} bezeichnet, und erstreckt sich entlang der Auslenkungspositionen bzw. Auslenkungszwischenpositionen z₁. Bei dem MEMS-Aktuator-Element 10 sind die Kantenstrukturen 14-1, 16-1 der ersten und zweiten Elektrodenstruktur 14, 16 hinsichtlich einer Draufsicht in einem lateralen Abstand x₀ gegenüberstehend ausgebildet. Gemäß einem Ausführungsbeispiel kann der vertikale Eintauchweg z_{E} ferner zwischen dem 0,1- und 0,4-fachen oder zwischen dem 0,2- und dem 0,3-fachen des maximalen Auslenkungswegs z_{S} betragen.

Gemäß der Erfindung sind die erste und zweite Elektrodenstruktur 14, 16 ausgebildet, um basierend auf einer elektrischen Ansteuerspannung V_{S} die zweite Elektrodenstruktur 16 in die Zwischenposition z₁ zwischen der minimalen Auslenkungsposition z_{MIN} und der maximalen Auslenkungsposition z_{MAX} elektrostatisch auszulenken. Dabei bewirkt ein Minimalwert der Ansteuerspannung VS eine Positionierung oder Auslenkung der Kantenstruktur 16-1 der zweiten Elektrodenstruktur 16 in die minimale Auslenkungsposition z_{MIN} und ein Maximalwert der Ansteuerspannung V_{S} eine Auslenkung der Kantenstruktur 16-1 der zweiten Elektrodenstruktur 16 in die maximale Auslenkungsposition z_{MAX}. Der Ansteuerspannungsbereich (= Adressspannungsbereich) liegt zwischen der minimalen Wert der Ansteuerspannung V_{S} und dem maximalen Wert der Ansteuerspannung V_{S}.

Ferner bewirkt eine Änderung der Ansteuerspannung Vs in einen Spannungswert zwischen der minimalen Ansteuerspannung V_{S_MIN} und der maximalen Ansteuerspannung V_{S_MAX} eine entsprechende Änderung der Zwischenposition z, der Kantenstruktur 16-1 der zweiten Elektrodenstruktur 16 zwischen deren minimaler und maximaler Auslenkungsposition z_{MIN} und z_{MAX}.

Gemäß der Erfindung ist das MEMS-Aktuator-Element 10 ferner ausgelegt, so dass die erste und zweite Elektrodenstruktur 14, 16 in einer Ebene parallel zu dem Substrat 12 um einen lateralen Mindestabstand x₀ beabstandet sind, wobei der laterale Mindestabstand x₀ das 0,5- bis 1,5-fache oder das 0,6- bis 1-fache des maximalen Auslenkungswegs z_{S} beträgt.

Gemäß der Erfindung ist das MEMS-Aktuator-Element 10 ferner ausgelegt, so dass die vertikale Dicke d₁₄, d der ersten und/oder zweiten Elektrodenstruktur 14, 16 das 0,6- bis 1,2-fache oder das 0,8- bis 1,0-fache des maximalen Auslenkungswegs z_{S} beträgt.

Gemäß einem Ausführungsbeispiel kann das MEMS-Aktuator-Element 10 ferner ausgelegt sein, so dass die minimale Ansteuerspannung als eine Biasspannung U_{BIAS} bereitgestellt wird, wobei die elektrische Ansteuerspannung V_{S} die Biasspannung U_{BIAS} und die Betriebsspannung (Adressspannung) V_{BETRIEB} aufweist, wobei die Biasspannung V_{BIAS} in einem Bereich zwischen dem 0,5-fachen bis 2-fachen oder dem 0,8-fachen bis 1,5-fachen des Betriebsspannungsbereichs liegen kann.

Bei Kammantrieben bzw. Kantenantrieben gemäß den beschriebenen Ausführungsbeispielen kann das elektrostatische Feld durch den relativ geringen Elektrodenabstand räumlich eng im Bereich der Elektrodenfinger 14-2, 16-2 begrenzt werden. Dadurch können relative hohe Aktuatorkräfte selbst bei der fertigungsbedingten Minimalgröße der Elektrodenstrukturen 14, 16 mit nur einigen wenigen Fingerelementen 14-2, 16-2 erreicht werden. Dazu erlaubt der beschriebene Kamm- bzw. Kantenantrieb ein geringes Übersprechen zwischen benachbarten Aktuatoren 10.

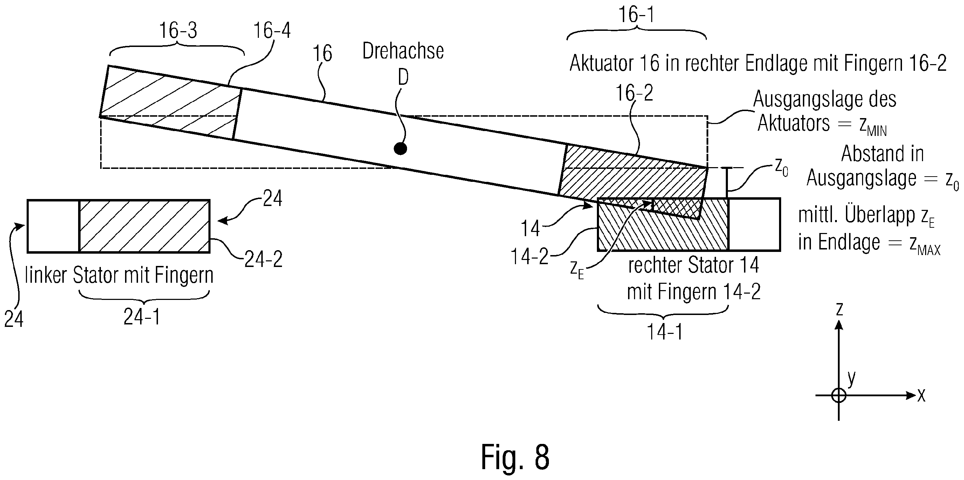

Fig. 8 zeigt eine schematische Querschnittsansicht senkrecht zu einer Kippachse durch einen Teil eines MEMS-Aktuator-Elements 10 gemäß einem Ausführungsbeispiel, wobei das MEMS-Aktuator-Element 10 als ein doppeltwirkender Kipp-Aktuator ausgebildet ist;

Gemäß einem Ausführungsbeispiel kann das MEMS-Aktuator-Element 10 eine dritte Elektrodenstruktur 24 aufweisen, die bezüglich des Substrats 12 feststehend und in der gleichen Ebene (parallel zur x-y-Ebene) wie die erste Elektrodenstruktur 14 angeordnet ist.

Die zweite Elektrodenstruktur 16 erstreckt sich bei dem Ausführungsbeispiel von Fig. 8 beidseitig symmetrisch zur Kipp- oder Drehachse D und weist beidseitig und beabstandet von der Kipp- oder Drehachse D jeweils eine erste Kantenstruktur 16-1 und eine zweite Kantenstruktur 16-3.

Die zweite Elektrodenstruktur 16 ist lateral (z.B. symmetrisch) zwischen der ersten und dritten Elektrodenstruktur 14, 24 angeordnet und auslenkbar. Dabei ist die zweite Elektrodenstruktur 16 mittels der ersten und dritten Elektrodenstruktur 14, 24 elektrostatisch von der minimalen Auslenkungsposition (= Ruheposition) z_{MIN} in eine vertikal beabstandete, weitere maximale Auslenkungsposition (= ober maximale Auslenkungsposition) z_{MAX'} bewegbar.

Die in Fig. 8 dargestellte Anordnung aus Fingerelementen 14-2, 16-2, 16-4 der Kantenstrukturen 14-1, 16-1, 16-3 ist (zumindest abschnittsweise) periodisch fortsetzbar, um die Kantenstrukturen 14-1, 16-1, 16-3 der ersten und zweiten Elektrodenstruktur 14, 16 zu bilden.

Bezüglich der geometrischen Anordnung der ersten und zweiten Elektrodenstruktur 14, 16 von Fig. 8 wird ferner auf die Ausführungen zu Fig. 7 verwiesen, die hier gleichermaßen anwendbar sind. So sind die Ausführungen zu der ersten und zweiten Elektrodenstruktur 14, 16 in Fig. 7 gleichermaßen auf beide beidseitig zu der Drehachse D angeordneten Kantenstrukturen 16-1, 16-3 der zweiten Elektrodenstruktur 16 bzgl. der jeweils zugeordneten ersten und dritten Elektrodenstruktur 14, 24 von Fig. 8 anwendbar, d.h. auf das Eintauchen der ersten Kantenstruktur 16-1 der zweiten Elektrodenstruktur 16 in die Kantenstruktur 14-1 der ersten Elektrodenstruktur 14 sowie auf das Eintauchen der zweiten Kantenstruktur 16-3 der zweiten Elektrodenstruktur 16 bei einer Drehbewegung um die Drehachse in die Kantenstruktur 24-1 der dritten Elektrodenstruktur 24.

Die gestrichelte Darstellung der zweiten Elektrodenstruktur 16 gibt beispielsweise eine minimale Auslenkungsposition (Grundposition) z_{MIN} der zweiten Elektrodenstruktur 16 wieder, während der durchgehend gezeichnete Umriss der zweiten Elektrodenstruktur 16 die maximale Auslenkposition z_{MAX} der zweiten Elektrodenstruktur 16 darstellt, wobei in Fig. 8 der vertikale Eintauchweg "z_{E}" (oder Überlapp) der ersten Kantenstruktur 16-1 der zweiten Elektrodenstruktur 16 in die Kantenstruktur 14-1 der ersten Elektrodenstruktur 14 dargestellt ist. Gleichermaßen kann ein vertikale Eintauchweg "z_{E}" (oder Überlapp) der zweiten Kantenstruktur 16-3 der zweiten Elektrodenstruktur 16 bei einer Drehbewegung um die Drehachse in die Kantenstruktur 24-1 der dritten Elektrodenstruktur 24 erreicht werden.

Die geometrischen und elektrischen Designparameter für das MEMS-Aktuator-Element 10 von Fig. 8 können wie bei den im Vorgehenden beschriebenen Ausführungsbeispielen angepasst und eingestellt werden.

Im Folgenden werden nochmals einige wesentliche technische Effekte des MEMS-Aktuator-Elements 100 zusammengefasst.

Das vorliegende erfindungsgemäße Konzept ermöglicht es, MEMS-Aktuator-Elemente 10 (= mikromechanische elektrostatische Aktuatoren) 10 mit großem Auslenkungsbereich bei kleinen lateralen Abmessungen zu realisieren, die gegenüber den üblichen Plattenaktuatoren ein sehr geringes Übersprechen zwischen Nachbarpixeln sowie eine verbesserte Linearität der Kennlinie zeigen.

Das vorliegende erfindungsgemäße Konzept eignet sich für mikromechanische Aktuatoren, insbesondere für phasenschiebende SLMs (SLM = Spatial Light Modulator, ein "Array" zur Modulation eines Laserstrahls) mit sehr kleinen Pixeln (gemessen an den herstellbaren mechanischen Strukturgrößen oder der gewünschten Auslenkung). Solche SLMs sind besonders für die digitale Holografie interessant, sowohl für zukünftige holografische Displays, wie auch für (etwas näher liegende) Anwendungen wie z.B. universelle Laserpinzetten, Wellenfrontmodellierung und schnelle optische Schalter für Glasfasernetze, wo solche SLMs die gleichzeitige Aufspaltung sowie Steuerung der Richtung, Divergenz und Intensität von Laserstrahlen ermöglichen. Aber auch die Verwendung in anderen Geräten zur Mustererzeugung oder Steuerung der Lichtverteilung erscheint sinnvoll. Darüber hinaus sind vielfältige andere Anwendungen in der Mikroaktuatorik (auch ohne Mikrospiegel) wie auch der Sensorik denkbar.

Das vorliegende erfindungsgemäße Konzept eignet sich auch für MEMS-Aktuatoren 10, bei denen mehr als zwei Stufen der Auslenkung dadurch erreicht werden, dass mehrere Elektroden jeweils unabhängig voneinander mit einem binären Spannungswert adressiert werden. Zum Beispiel können der beweglichen Elektrode (auf festem elektrischem Potenzial, Biasspannung) 4 elektrisch getrennte, feste Elektroden gegenüberstehen, die jeweils an einer SRAM-Speicherzelle der Adresselektronik angeschlossen sind. Jede SRAM-Zelle kann jeweils nur einen von zwei Zuständen annehmen und die angeschlossene Elektrode mit einer von zwei Spannungen beaufschlagen. Wenn die 4 Elektroden durch unterschiedliche Kantenlängen (Fingerzahlen) unterschiedlich starke Kräfte erzeugen, können so mit einer rein digitalen Ansteuerung im Beispiel bis zu 16 Stufen im analogen Auslenkungsbereich des Aktuators angesteuert werden, d.h. ohne einen pull-in und ohne mechanische Anschläge. In diesem Fall kann durch die relativ gute Linearität der Kennlinie dieser Erfindung eine deutliche Verbesserung der Abstufung der Auslenkungszustände gegenüber einem Plattenaktuator mit mehreren Elektroden erreicht werden. Entsprechendes ginge grundsätzlich auch mit einer festen und mehreren beweglichen Elektroden.

Die vorliegende Erfindung kann sehr gut mit Federn entsprechend des Patents [8] oder noch besser der Anmeldung [9] kombiniert werden.

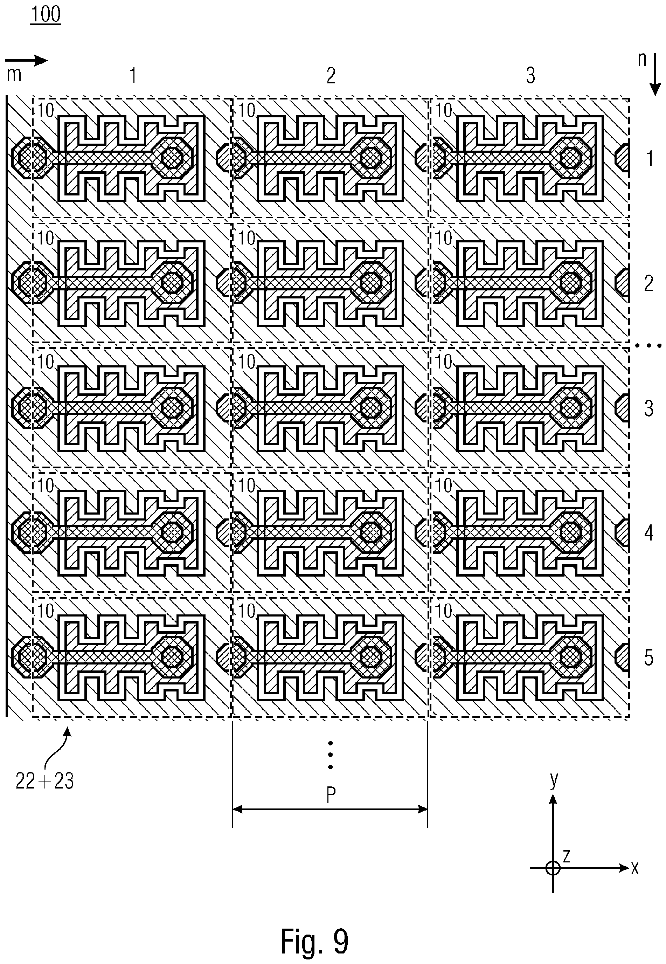

Fig. 9 zeigt eine schematische Aufsicht auf ein regelmäßiges MEMS-Array 100 von MEMS-Aktuator-Elementen 10 gemäß einem Ausführungsbeispiel. Das MEMS-Array 100 von Fig. 9 weist eine Vielzahl von symmetrisch angeordneten MEMS-Aktuator-Elementen 10, wie z.B. die rechteckigen MEMS-Aktuator-Elemente 10 von Fig. 4. Es sollte aber deutlich werden, dass die dargestellte Array-Anordnung mit allen im vorhergehenden beschriebenen MEMS-Aktuator-Elementen 10 umgesetzt werden kann.

Fig. 9 zeigt beispielhaft das MEMS-Aktuator-Array 100 in einer nxm-Arrayanordnung (n, m = positive ganze Zahlen), mit n = 5 Zeilen und m = 3 Spalten. Die Zeilen und Spalten sind aber im Wesentlichen beliebig fortsetzbar, um das MEMS-Aktuator-Array 100 mit zumindest 10.000 MEMS-Aktuator-Elementen 10 zu erhalten.

Gemäß einem Ausführungsbeispiel umfasst das MEMS-Aktuator-Array 100 eine Mehrzahl von MEMS-Aktuator-Elementen 10 und ferner einer Ansteuereinrichtung 22 zum Bereitstellen einer eigenen Ansteuerspannung zwischen der ersten und zweiten Elektrodenstruktur 14, 16 der jeweiligen MEMS-Aktuator-Elemente 10. Die Ansteuereinrichtung 22 ist beispielsweise ausgebildet , um jedes einzelne oder unterschiedliche Gruppen der MEMS-Aktuator-Elemente 10 mit einer eigenen Ansteuerspannung V_{S} zu versehen.

Gemäß einem Ausführungsbeispiel kann zumindest eine Teilmenge der MEMS-Aktuator-Elemente 10 oder können auch alle MEMS-Aktuator-Elemente 10 eine gemeinsame erste Elektrodenstruktur 14 aufweist, die bezüglich des Substrats 12 feststehend angeordnet ist.

Gemäß einem Ausführungsbeispiel kann zumindest eine Teilmenge der MEMS-Aktuator-Elemente 10 oder können auch alle MEMS-Aktuator-Elemente 10 eine gemeinsame dritte Elektrodenstruktur aufweist, die bezüglich des Substrats feststehend angeordnet ist, wobei die Ansteuereinrichtung 22 ferner ausgebildet ist, um eine weitere eigene Ansteuerspannung zwischen der zweiten und dritten Elektrodenstruktur 14, 24 der jeweiligen MEMS-Aktuator-Elemente 10 bereitzustellen.

Gemäß einem Ausführungsbeispiel können die MEMS-Aktuator-Elemente 10 Mikrospiegelelemente 20 aufweisen, die jeweils mit einer der zweiten Elektrodenstrukturen 16 gekoppelt sind, wobei die Mikrospiegelelemente 20 entsprechend der Auslenkung der zugeordneten zweiten Elektrodenstruktur 16 auslenkbar sind.

Gemäß einem Ausführungsbeispiel sind die zweiten Elektrodenstrukturen 16 der MEMS-Aktuator-Elemente 10 basierend auf der Ansteuerspannung Vs in zumindest eine Zwischenposition z₁ jeweils zwischen der minimalen und maximalen Auslenkungsposition z_{MIN}, z_{MAX} und/oder basierend auf der weiteren Ansteuerspannung V'_{S} in zumindest eine weitere Zwischenposition z'₁ jeweils zwischen der minimalen Auslenkungsposition z_{MIN} und weiteren maximalen Auslenkungsposition z'_{MAX} auslenkbar.

Gemäß einem Ausführungsbeispiel weisen die Ansteuerspannung Vs und/oder die weitere Ansteuerspannung V'_{S} eine jeweilige Adressspannung V_{BETRIEB}, V'_{BETRIEB} für die MEMS-Aktuator-Elemente 10 und ferner eine jeweilige Bias-Spannung V_{BIAS}, V'_{BIAS} für die MEMS-Aktuator-Elemente 10 auf, wobei die Bias-Spannung V_{BIAS}, V'_{BIAS} in einem Bereich zwischen dem 0,5-fachen und 2-fachen, oder zwischen dem 0,8-fachen und 1,5-fachen eines Maximalwerts der Adressspannung V_{BETRIEB}, V'_{BETRIEB} liegt.

Gemäß einem Ausführungsbeispiel weist das MEMS-Aktuator-Array 100 ferner einer CMOS-Backplane als das Substrat 12 auf, wobei die CMOS-Backplane die Ansteuereinrichtung 22 und ferner Speicherzellen 23 aufweist.

Gemäß einem Ausführungsbeispiel weist das MEMS-Aktuator-Array 100 zumindest 10.000 MEMS-Aktuator-Elemente 10 in einer nxm-Anordnung, mit n Zeilen und m Spalten, auf. Gemäß einem Ausführungsbeispiel weisen die MEMS-Aktuator-Elemente 10 des MEMS-Aktuator-Arrays 100 einen Pitch P von kleiner oder gleich 20µm oder 10µm auf. Gemäß einem Ausführungsbeispiel weisen die MEMS-Aktuator-Elemente 10 des MEMS-Aktuator-Arrays 100 einen Pitch P zwischen 5µm und 20µm auf.

Gemäß einem Ausführungsbeispiel umfasst also das MEMS-Aktuator-Array 100 eine Mehrzahl von MEMS-Aktuator-Elementen 10, wobei die MEMS-Aktuator-Elemente 10 ein Substrat 12, eine erste Elektrodenstruktur 14 mit einer Kantenstruktur 14-1, die bezüglich des Substrats 12 feststehend angeordnet ist, und eine zweite Elektrodenstruktur 16 mit einer Kantenstruktur 16-1.

Die zweite Elektrodenstruktur 16 ist mittels einer Federstruktur 18 auslenkbar mit dem Substrat 12 gekoppelt und ist mittels der ersten Elektrodenstruktur 14 elektrostatisch auslenkbar, um die Kantenstruktur 16-1 der zweiten Elektrodenstruktur 16 in eine Zwischenposition z₁ zwischen einer minimalen Auslenkungsposition z_{MIN} und einer vertikal beabstandeten maximalen Auslenkungsposition z_{MAX} zu bewegen, wobei die minimale und maximale Auslenkungsposition z_{MIN}, z_{MAX} einen maximalen Auslenkungswegs z_{S} vorgeben.

Die Kantenstrukturen 14-1, 16-1 der ersten und zweiten Elektrodenstruktur 14, 16 sind hinsichtlich einer Draufsicht gegenüberstehend ausgebildet und in der minimalen Auslenkposition z_{MIN} vertikal voneinander beabstandet.

In der maximalen Auslenkposition z_{MAX} beträgt der vertikale Eintauchweg z_{E} der Kantenstruktur 16-1 der zweiten Elektrodenstruktur 16 in die Kantenstruktur 14-1 der ersten Elektrodenstruktur 14 bis zu dem 0,5-fachen des maximalen Auslenkungswegs zs, mit z_{E} ≤ 0,5 Zs.

Die erste und zweite Elektrodenstruktur 14, 16 sind in einer Ebene parallel zu dem Substrat 12 um einen lateralen Mindestabstand (= um einen mittleren bzw. effektiven lateralen Abstand) x₀ beabstandet sind, wobei der laterale Mindestabstand x₀ das 0,5- bis 1,5-fache oder das 0,6- bis 1-fache des maximalen Auslenkungswegs z_{S} beträgt.

Die vertikale Dicke (= mittlere bzw. effektive vertikale Dicke) d₁₄, d₁₆ der ersten und/oder zweiten Elektrodenstruktur 14, 16 beträgt das 0,6- bis 1,2-fache oder das 0,8- bis 1,0-fache des maximalen Auslenkungswegs z_{S}.

Die MEMS-Aktuator-Elemente 10 weisen einen Pitch P von kleiner oder gleich 20µm auf. Das MEMS-Aktuator-Array 100 umfasst ferner eine Ansteuereinrichtung 22 zum Bereitstellen einer eigenen Ansteuerspannung V_{S} zwischen der ersten und zweiten Elektrodenstruktur 14, 16 der jeweiligen MEMS-Aktuator-Elemente 10.

Gemäß einem Ausführungsbeispiel beträgt in der maximalen Auslenkungsposition z_{MAX} der vertikale Eintauchweg z_{E} der Kantenstruktur 16-1 der zweiten Elektrodenstruktur 16 bezüglich die Kantenstruktur 14-1 der ersten Elektrodenstruktur 14 zwischen dem 0,1- und 0,4-fachen oder zwischen dem 0,2- und dem 0,3-fachen des maximalen Auslenkungswegs z_{S}.

Basierend auf den obigen Designparametern für das MEMS-Aktuator-Element kann nun die für die jeweilige Anwendung gewünschte bzw. geforderte maximale Auslenkung z_{S} (Stroke) eingestellt werden, wobei für diese durch die Anwendung geforderte bzw. vorgegebene Größe der maximalen Auslenkung ein MEMS-Aktuator-Element mit für den jeweiligen Anwendungsfall optimierten (= minimalen) Abmessungen (Pitch), einer optimierten (= minimalen) Antriebsspannung, einer linearen Kennlinie und einem geringen Übersprechen zu benachbarten MEMS-Aktuator-Elementen erhalten werden kann.

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen. Folglich werden die folgenden Ansprüche hiermit in die detaillierte Beschreibung aufgenommen, wobei jeder Anspruch als ein eigenes separates Beispiel stehen kann. Während jeder Anspruch als ein eigenes separates Beispiel stehen kann, sei angemerkt, dass, obwohl sich abhängige Ansprüche in den Ansprüchen auf eine spezifische Kombination mit einem oder mehreren anderen Ansprüchen zurückbeziehen, andere Beispiele auch eine Kombination von abhängigen Ansprüchen mit dem Gegenstand jedes anderen abhängigen Anspruchs oder einer Kombination jedes Merkmals mit anderen abhängigen oder unabhängigen Ansprüchen umfassen. Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist.

Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der vorliegenden Anmeldung abzuweichen. Dieser Anmeldungstext soll alle Adaptionen und Variationen der hierin beschriebenen und erörterten spezifischen Ausführungsbeispiele abdecken. Daher ist der vorliegende Anmeldungsgegenstand lediglich durch den Wortlaut der Ansprüche begrenzt.

### Literatur

1. Peter Dürr, Andreas Gehner, Jan Schmidt, Detlef Kunze, Michael Wagner, Hubert Lakner: 'Micro-actuator with extended analog deflection at low drive voltage', Proceedings of SPIE Vol. 6114 (2006)
2. A. Gehner et al., "Micromirror arrays for wavefront correction", SPIE Vol. 4178, pp. 348-357 (2000).
3. Hubert Lakner et al.: "Design and Fabrication of Micromirror Arrays for UV-Lithography", Proc of SPIE Vol. 4561 (2001)
4. Harald Schenk et al.: "A Novel Electrostatically Driven Torsional Actuator", Proc. 3rd Int. Conf. on Micro Opto Electro Mechanical Systems (1999)
5. L. Clark et al.: 'Vertical comb drive actuated deformable mirror device and method', Patent US 6,384,952
6. T. Sandner: 'Method of fabricating a micromechanical out of two-dimensional ...', Patent US 7929192
7. Veljko Milanovic et al.: 'Gimbal-less micro-electro-mechanical system ...', Patent US7295726
8. Peter Dürr et al.: 'MEMS Aktuator, System mit einer Mehrzahl vom MEMS Aktuatoren und Verfahren ...', Patent DE102015200626, patent application US2017297897AA
9. Peter Dürr et al.: 'MEMS mit einem beweglichen Strukturelement und MEMS-Array', deutsche Patentanmeldung 102018207783.5 (noch nicht veröffentlicht)

## Patentansprüche

1. MEMS-Aktuator-Element (10), mit folgenden Merkmalen:
einem Substrat (12),
einer ersten Elektrodenstruktur (14) mit einer Kantenstruktur (14-1), die bezüglich des Substrats (12) feststehend angeordnet ist,
einer zweiten Elektrodenstruktur (16) mit einer Kantenstruktur (16-1), wobei die zweite Elektrodenstruktur (16) mittels einer Federstruktur (18) auslenkbar mit dem Substrat (12) gekoppelt ist und mittels einer Ansteuerspannung (V_{S}) zwischen der ersten und zweiten Elektrodenstruktur (14, 16) elektrostatisch auslenkbar ist, um die Kantenstruktur (16-1) der zweiten Elektrodenstruktur (16) in eine Zwischenposition (z₁) zwischen einer minimalen Auslenkungsposition (z_{MIN}) und einer vertikal beabstandeten maximalen Auslenkungsposition (z_{MAX}) zu bewegen, wobei die minimale und maximale Auslenkungsposition (z_{MIN}, z_{MAX}) einen maximalen Auslenkungsweg (z_{S}) vorgeben,
wobei die Kantenstrukturen (14-1, 16-1) der ersten und zweiten Elektrodenstruktur (14, 16) hinsichtlich einer Draufsicht gegenüberstehend ausgebildet und in der minimalen Auslenkposition (z_{MIN}) vertikal voneinander beabstandet sind, und wobei die erste und zweite Elektrodenstruktur (14, 16) in einer Ebene parallel zu dem Substrat (12) um einen lateralen Mindestabstand (x₀) beabstandet sind, wobei die vertikale Richtung senkrecht zur Substratebene ist, **dadurch gekennzeichnet, dass** der laterale Mindestabstand (x₀) das 0,5-bis 1,5-fache oder das 0,6- bis 1-fache des maximalen Auslenkungswegs (z_{S}) beträgt, und wobei die vertikale Dicke (d₁₄, d₁₆) der ersten und/oder zweiten Elektrodenstruktur (14, 16) das 0,6- bis 1,2-fache oder das 0,8- bis 1,0-fache des maximalen Auslenkungswegs (z_{S}) beträgt, und
in der maximalen Auslenkposition (z_{MAX}) der vertikale Eintauchweg (z_{E}) der Kantenstruktur (16-1) der zweiten Elektrodenstruktur (16) in die Kantenstruktur (14-1) der ersten Elektrodenstruktur (14) bis zu dem 0,5-fachen des maximalen Auslenkungswegs zs, mit z_{E} ≤ 0,5 zs, beträgt, und
das MEMS-Aktuator-Element (10) eine Ansteuereinrichtung (22) umfasst, ausgebildet zum Bereitstellen der Ansteuerspannung (Vs) begrenzt durch eine minimale Ansteuerspannung (V_{S-MIN}) und eine maximale Ansteuerspannung (V_{S-MAX}) zwischen der ersten und zweiten Elektrodenstruktur (14, 16), um basierend auf der elektrischen Ansteuerspannung (Vs) die zweite Elektrodenstruktur (16) in die Zwischenposition (z₁) zwischen der minimalen Auslenkungsposition (z_{MIN}) und der maximalen Auslenkungsposition (z_{MAX}) elektrostatisch auszulenken, wobei die minimale Ansteuerspannung (V_{S_MIN}) eine Auslenkung der Kantenstruktur (16-1) der zweiten Elektrodenstruktur (16) in die minimale Auslenkungsposition (z_{MIN}) und die maximale Ansteuerspannung (V_{S_MAX}) eine Auslenkung in die maximale Auslenkungsposition (z_{MAX}) bewirkt.

2. M EMS-Aktuator-Element (10) gemäß Anspruch 1, wobei eine Änderung der Ansteuerspannung (V_{S}) in eine Zwischenspannung zwischen der minimalen Ansteuerspannung und der maximalen Ansteuerspannung eine entsprechende Änderung der Zwischenposition (z₁) der Kantenstruktur (16-1) der zweiten Elektrodenstruktur (16) zwischen der minimalen Auslenkungsposition (z_{MIN}) und maximalen Auslenkungsposition (z_{MAX}) bewirkt.

3. MEMS-Aktuator-Element (10) gemäß einem der vorhergehenden Ansprüche, wobei in der maximalen Auslenkungsposition (z_{MAX}) der vertikale Eintauchweg (z_{E}) der Kantenstruktur (16-1) der zweiten Elektrodenstruktur (16) bezüglich der Kantenstruktur (14-1) der ersten Elektrodenstruktur (14) zwischen dem 0,1- und 0,4-fachen oder zwischen dem 0,2- und dem 0,3-fachen des maximalen Auslenkungswegs (z_{S}) beträgt

4. MEMS-Aktuator-Element (10) gemäß einem der vorhergehenden Ansprüche, wobei die minimale Ansteuerspannung (V_{S_MIN}) als eine Bias-Spannung (V_{BIAS}) bereitgestellt wird, und wobei die elektrische Ansteuerspannung (V_{S}) die Bias-Spannung (V_{BIAS}) und eine Betriebsspannung (V_{BETRIEB}) aufweist, wobei die Bias-Spannung (V_{BIAS}) in einem Bereich zwischen dem 0,5-fachen bis 2-fachen oder dem 0,8-fachen bis 1,5-fachen des Betriebsspannungsbereichs liegt.

5. M EMS-Aktuator-Element (10) gemäß einem der vorhergehenden Ansprüche, wobei die zweite Elektrodenstruktur (16) translatorisch und/oder rotatorisch bezüglich der ersten Elektrodenstruktur (14) auslenkbar ist.

6. MEMS-Aktuator-Element (10) gemäß einem der vorhergehenden Ansprüche, wobei die Kantenstruktur (16-1) der zweiten Elektrodenstruktur (16) hinsichtlich einer Draufsicht ineinandergreifend zu der Kantenstruktur (14-1) der ersten Elektrodenstruktur (14) ausgebildet, wobei die Kantenstruktur (14-1) der ersten Elektrodenstruktur (14) eine Finger- oder Kammstruktur (14-2) aufweist, und wobei die Kantenstruktur (16-1) der zweiten Elektrodenstruktur (16) eine weitere Finger- oder Kammstruktur (16-2) aufweist.

7. MEMS-Aktuator-Element (10) gemäß einem der vorhergehenden Ansprüche, ferner mit folgendem Merkmal:
einer dritten Elektrodenstruktur (24), die bezüglich des Substrats (12) feststehend angeordnet ist, wobei die zweite Elektrodenstruktur (16) zwischen der ersten und dritten Elektrodenstruktur (14, 24) angeordnet und auslenkbar ist, wobei die zweite Elektrodenstruktur (16) mittels der ersten und dritten Elektrodenstruktur (14, 24) elektrostatisch von der minimalen Auslenkungsposition (z_{MIN}) in eine vertikal beabstandete, weitere maximale Auslenkungsposition (z'_{MAX}) bewegbar ist.

8. MEMS-Aktuator-Array (100), mit folgenden Merkmalen:
einer Mehrzahl von MEMS-Aktuator-Elementen (10) gemäß einem der vorhergehenden Ansprüche,
wobei die Ansteuereinrichtung (22) ausgebildet ist, um eine eigene Ansteuerspannung (Vs) zwischen der ersten und zweiten Elektrodenstruktur (14, 16) der jeweiligen MEMS-Aktuator-Elemente (10) bereitzustellen.

9. MEMS-Aktuator-Array (100) gemäß Anspruch 8, wobei zumindest eine Teilmenge oder alle MEMS-Aktuator-Elemente (10) eine gemeinsame erste Elektrodenstruktur (14) aufweist, die bezüglich des Substrats (12) feststehend angeordnet ist.

10. MEMS-Aktuator-Array (100) gemäß Anspruch 8 oder 9, wobei zumindest eine Teilmenge oder alle MEMS-Aktuator-Elemente (10) eine gemeinsame dritte Elektrodenstruktur (24) aufweist, die bezüglich des Substrats (12) feststehend angeordnet ist, und
wobei die Ansteuereinrichtung (22) ferner ausgebildet ist, um eine weitere Ansteuerspannung (V's) zwischen der zweiten und dritten Elektrodenstruktur (16, 24) bereitzustellen.

11. MEMS-Aktuator-Array (100) gemäß einem der Ansprüche 8 bis 10, wobei die MEMS-Aktuator-Elemente (10) Mikrospiegelelemente (20), die jeweils mit einer der zweiten Elektrodenstrukturen (16) gekoppelt sind, aufweisen, wobei die Mikrospiegelelemente (20) entsprechend der Auslenkung der zweiten Elektrodenstruktur (16) auslenkbar sind.

12. MEMS-Aktuator-Array (100) gemäß einem der Ansprüche 8 bis 11, wobei die zweiten Elektrodenstrukturen (16) der MEMS-Aktuator-Elemente (10) basierend auf der Ansteuerspannung (V_{S}) in zumindest eine Zwischenposition (z₁) jeweils zwischen der minimalen und maximalen Auslenkungsposition (z_{MIN}, z_{MAX})und/oder basierend auf der weiteren Ansteuerspannung (V's) in zumindest eine Zwischenposition (z₁) jeweils zwischen der minimalen Auslenkungsposition (z_{MIN}) und weiteren maximalen Auslenkungsposition (z'_{MAX}) auslenkbar sind.

13. MEMS-Aktuator-Array (100) gemäß einem der Ansprüche 8 bis 12, mit folgenden Merkmalen:
Einer CMOS-Backplane (12) als das Substrat (12), wobei die CMOS-Backplane (12) die Ansteuereinrichtung (22) und ferner Speicherzellen (23) aufweist.

14. MEMS-Aktuator-Array (100) gemäß einem der Ansprüche 8 bis 13, wobei das MEMS-Aktuator-Array (100) zumindest 10.000 MEMS-Aktuator-Elemente (10) aufweist.

15. MEMS-Aktuator-Array (100) gemäß einem der Ansprüche 8 bis 14, wobei die MEMS-Aktuator-Elemente (10) einen Pitch (P) von kleiner oder gleich 20µm aufweisen.

## Claims

1. MEMS actuator element (10), comprising:
a substrate (12),
a first electrode structure (14) with an edge structure (14-1) that is stationary with respect to the substrate (12),
a second electrode structure (16) with an edge structure (16-1), wherein the second electrode structure (16) is deflectably coupled to the substrate (12) by means of a spring structure (18) and electrostatically deflectable by means of an control voltage (V_{S}) between the first and second electrode structures (14, 16) to move the edge structure (16-1) of the second electrode structure (16) into an intermediate position (z₁) between a minimum deflection position (z_{MIN}) and a vertically spaced-apart maximum deflection position (z_{MAX}), wherein the minimum and maximum deflection positions (z_{MIN}, z_{MAX})specify a maximum deflection path (z_{S}),
wherein the edge structures (14-1, 16-1) of the first and second electrode structures (14, 16) are configured to be opposite to each other with respect to a top view and are vertically spaced apart in the minimum deflection position (z_{MIN}) and wherein the first and second electrode structures (14, 16) are spaced apart by a lateral minimum distance (x₀) in a plane parallel to the substrate (12), wherein the vertical direction is perpendicular to the substrate plane, **characterized in that** the lateral minimum distance (x₀) is 0.5 to 1.5 times or 0.6 to 1 times the maximum deflection path (zs), and wherein the vertical thickness (d₁₄, d₁₆) of the first and/or second electrode structure (14, 16) is 0.6 to 1.2 times or 0.8 to 1.0 times the maximum deflection path (z_{S}), and
in the maximum deflection position (z_{MAX}), the vertical immersion path (z_{E}) of the edge structure (16-1) of the second electrode structure (16) into the edge structure (14-1) of the first electrode structure (14) is up to 0.5 times the maximum deflection path zs, with z_{E} ≤ 0,5 z_{S}, and
the MEMS actuator element (10) comprises control means (22) configured for providing a control voltage (V_{S}) limited by a minimum control voltage (V_{S_MIN}) and a maximum control voltage (V_{S_MAX}) between the first and second electrode structures (14, 16) to electrostatically deflect the second electrode structure (16) into the intermediate position (z₁) between the minimum deflection position (z_{MIN}) and the maximum deflection position (z_{MAX}) based on the electric control voltage (V_{S}), wherein the minimum control voltage (V_{S_MIN}) effects deflection of the edge structure (16-1) of the second electrode structure (16) into the minimum deflection position (z_{MIN}) and the maximum control voltage (V_{S_MAX}) effects deflection into the maximum deflection position (z_{MAX}).

2. MEMS actuator element (10) according to claim 1, wherein a change of the control voltage (V_{S}) into an intermediate voltage between the minimum control voltage and the maximum control voltage effects a respective change of the intermediate position (z₁) of the edge structure (16-1) of the second electrode structure (16) between the minimum deflection position (z_{MIN}) and the maximum deflection position (ZMAX).

3. MEMS actuator element (10) according to one of the preceding claims, wherein, in the maximum deflection position (z_{MAX}), the vertical immersion path (z_{E}) of the edge structure (16-1) of the second electrode structure (16) with respect to the edge structure (14-1) of the first electrode structure (14) is between 0.1 and 0.4 times or between 0.2 and 0.3 times the maximum deflection path (z_{S}).

4. MEMS actuator element (10) according to one of the preceding claims, wherein the minimum control voltage (V_{S_MIN}) is provided as bias voltage (V_{BIAS}), and wherein the electric control voltage (Vs) comprises the bias voltage (V_{BIAS}) and an operating voltage (V_{OPERATION}), wherein the bias voltage (V_{BIAS}) is in a range between 0.5 times to 2 times or 0.8 times to 1.5 times the operating voltage range.

5. MEMS actuator element (10) according to one of the preceding claims, wherein the second electrode structure (16) is deflectable in a translatory and/or rotatory manner with respect to the first electrode structure (14).

6. MEMS actuator element (10) according to one of the preceding claims, wherein the edge structure (16-1) of the second electrode structure (16) is configured to engage the edge structure (14-1) of the first electrode structure (14) with respect to a top view, wherein the edge structure (14-1) of the first electrode structure (14) comprises a finger or comb structure (14-2) and wherein the edge structure (16-1) of the second electrode structure (16) comprises a further finger or comb structure (16-2).

7. MEMS actuator element (10) according to one of the preceding claims, further comprising:
a third electrode structure (24) that is stationary with respect to the substrate (12), wherein the second electrode structure (16) is arranged between the first and third electrode structures (14, 24) and is deflectable, wherein the second electrode structure (16) is electrostatically moveable from the minimum deflection position (z_{MIN}) into a vertically spaced-apart further maximum deflection position (z'_{MAX}) by means of the first and third electrode structures (14, 24).

8. MEMS actuator array (100), comprising:
a plurality of MEMS actuator elements (10) according to one of the preceding claims
wherein the control means (22) is configured for providing an individual control voltage (V_{S}) between the first and second electrode structures (14, 16) of the respective MEMS actuator elements (10).

9. MEMS actuator array (100) according to claim 8, wherein at least a subset or all MEMS actuator elements (10) comprise a common first electrode structure (14) that is stationary with respect to the substrate (12).

10. MEMS actuator array (100) according to claim 8 or 9, wherein at least a subset or all MEMS actuator elements (10) comprise a common third electrode structure (24) that is stationary with respect to the substrate (12) and
wherein the control means (22) is further configured to provide a further control voltage (V's) between the second and third electrode structures (16, 24).

11. MEMS actuator array (100) according to one of claims 8 to 10, wherein the MEMS actuator elements (10) comprise micromirror elements (20) that are each coupled to one of the second electrode structures (16), wherein the micromirror elements (20) are deflectable according to the deflection of the second electrode structure (16).

12. MEMS actuator array (100) according to one of claims 8 to 11, wherein the second electrode structures (16) of the MEMS actuator elements (10) are deflectable into at least one intermediate position (z₁) each between the minimum and maximum deflection position (z_{MIN}, z_{MAX}), based on the control voltage (Vs) and/or into at least an intermediate position (z₁), each between the minimum deflection position (z_{MIN}) and further maximum deflection position (z'_{MAX}), based on the further control voltage (V's).

13. MEMS actuator array (100) according to one of claims 8 to 12, comprising:
a CMOS backplane (12) as the substrate (12), wherein the CMOS backplane (12) comprises the control means (22) and further memory cells (23).

14. MEMS actuator array (100) according to one of claims 8 to 13, wherein the MEMS actuator array (100) comprises at least 10,000 MEMS actuator elements (10).

15. MEMS actuator array (100) according to one of claims 8 to 14, wherein the MEMS actuator elements (10) comprise a pitch (P) of less than or equal to 20µm.

## Revendications

1. Elément d'actionneur de type MEMS (10), aux caractéristiques suivantes:
un substrat (12),
une première structure d'électrodes (14) avec une structure de bords (14-1) qui est disposée de manière fixe par rapport au substrat (12),
une deuxième structure d'électrodes (16) avec une structure de bords (16-1), où la deuxième structure d'électrodes (16) est couplée au substrat (12), au moyen d'une structure de ressorts (18), de manière à pouvoir être déviée, et peut être déviée de manière électrostatique, au moyen d'une tension de commande (V_{S}), entre la première et la deuxième structure d'électrodes (14, 16) pour déplacer la structure de bords (16-1) de la deuxième structure d'électrodes (16) vers une position intermédiaire (z₁) entre une position de déviation minimale (z_{MIN}) et une position de déviation maximale (z_{MAX}) distante verticalement, où la position de déviation minimale et la position de déviation maximale (z_{MIN}, z_{MAX}) définissent un trajet de déviation maximum (z_{S}),
dans lequel les structures de bords (14-1, 16-1) de la première et de la deuxième structure d'électrodes (14, 16) sont conçues l'une face à l'autre en ce qui concerne une vue en plan et sont verticalement distantes l'une de l'autre dans la position de déviation minimale (z_{MIN}), et dans lequel la première et la deuxième structure d'électrodes (14, 16) sont distantes l'une de l'autre dans un plan parallèle au substrat (12) d'une distance latérale minimale (x₀), dans lequel la direction verticale est perpendiculaire au plan du substrat,
**caractérisé par le fait que** la distance latérale minimale (x₀) est de 0,5 à 1,5 fois ou de 0,6 à 1 fois le trajet de déviation maximum (z_{S}), et où l'épaisseur verticale (d₁₄, d₁₆) de la première et/ou de la deuxième structure d'électrodes (14, 16) est de 0,6 à 1,2 fois ou de 0,8 à 1,0 fois le trajet de déviation maximum (zs), et
dans la position de déviation maximale (z_{MAX}), le trajet d'immersion vertical (z_{E}) de la structure de bords (16-1) de la deuxième structure d'électrodes (16) dans la structure de bords (14-1) de la première structure d'électrodes (14) est de jusqu'à 0,5 fois le trajet de déviation maximum zs, où z_{E} ≤ 0,5 z_{S}, et
l'élément d'actionneur de type MEMS (10) comporte un moyen de commande (22), conçu pour fournir la tension de commande (V_{S}) limitée par une tension de commande minimale (V_{S-MIN}) et une tension de commande maximale (V_{S-MAX}) entre la première et la deuxième structure d'électrodes (14, 16), pour dévier de manière électrostatique, sur base de la tension de commande électrique (V_{S}), la deuxième structure d'électrodes (16) vers la position intermédiaire (z₁) entre la position de déviation minimale (z_{MIN}) et la position de déviation maximale (z_{MAX}), où la tension de commande minimale (V_{S_MIN}) provoque une déviation de la structure de bords (16-1) de la deuxième structure d'électrodes (16) vers la position de déviation minimale (z_{MIN}) et la tension de commande maximale (V_{S_MAX}) provoque une déviation vers la position de déviation maximale (z_{MAX}).

2. Elément d'actionneur de type MEMS (10) selon la revendication 1, dans lequel un changement de la tension de commande (Vs) en une tension intermédiaire entre la tension de commande minimale et la tension de commande maximale provoque un changement correspondant de la position intermédiaire (z₁) de la structure de bords (16-1) de la deuxième structure d'électrodes (16) entre la position de déviation minimale (z_{MIN}) et la position de déviation maximale (z_{MAX}).

3. Elément d'actionneur de type MEMS (10) selon l'une des revendications précédentes, dans lequel, dans la position de déviation maximale (z_{MAX}), le trajet d'immersion vertical (z_{E}) de la structure de bords (16-1) de la deuxième structure d'électrodes (16) par rapport à la structure de bords (14-1) de la première structure d'électrodes (14) est compris entre 0,1 et 0,4 fois ou entre 0,2 et 0,3 fois le trajet de déviation maximum (z_{S}).

4. Elément d'actionneur de type MEMS (10) selon l'une des revendications précédentes, dans lequel la tension de commande minimale (V_{S_MIN}) est fournie sous forme d'une tension de polarisation (V_{BIAS}), et dans lequel la tension de commande électrique (Vs) présente la tension de polarisation (V_{BIAS}) et une tension de fonctionnement (V_{BETRIEB}), dans lequel la tension de polarisation (V_{BIAS}) se situe dans une plage comprise entre 0,5 fois et 2 fois ou entre 0,8 fois et 1,5 fois la plage de tension de fonctionnement.

5. Elément d'actionneur de type MEMS (10) selon l'une des revendications précédentes, dans lequel la deuxième structure d'électrodes (16) peut être déviée en translation et/ou en rotation par rapport à la première structure d'électrodes (14).

6. Elément d'actionneur de type MEMS (10) selon l'une des revendications précédentes, dans lequel la structure de bords (16-1) de la deuxième structure d'électrodes (16) est conçue, en ce qui concerne une vue de dessus, de manière à s'emboîter avec la structure de bords (14-1) de la première structure d'électrodes (14), dans lequel la structure de bords (14-1) de la première structure d'électrodes (14) présente une structure de doigts ou de peigne (14-2), et dans lequel la structure de bords (16-1) de la deuxième structure d'électrodes (16) présente une autre structure de doigts ou de peigne (16-2).

7. Elément d'actionneur de type MEMS (10) selon l'une des revendications précédentes, par ailleurs à la caractéristique suivante:
une troisième structure d'électrodes (24) qui est disposée de manière fixe par rapport au substrat (12), où la deuxième structure d'électrodes (16) est disposée et peut être déviée entre la première et la troisième structure d'électrodes (14, 24), où la deuxième structure d'électrodes (16) peut être déplacée de manière électrostatique, au moyen de la première et de la troisième structure d'électrodes (14, 24), de la position de déviation minimale (z_{MIN}) vers une autre position de déviation maximale (z'_{MAX}) distante verticalement.

8. Réseau d'actionneurs de type MEMS (100), aux caractéristiques suivantes:
une pluralité d'éléments d'actionneur de type MEMS (10) selon l'une des revendications précédentes,
dans lequel le dispositif de commande (22) est conçu pour fournir sa propre tension de commande (Vs) entre la première et la deuxième structure d'électrodes (14, 16) des éléments d'actionneur de type MEMS respectifs (10).

9. Réseau d'actionneurs de type MEMS (100) selon la revendication 8, dans lequel au moins une quantité partielle ou tous les éléments d'actionneur de type MEMS (10) présentent une première structure d'électrodes commune (14) qui est disposée de manière fixe par rapport au substrat (12).

10. Réseau d'actionneurs de type MEMS (100) selon la revendication 8 ou 9, dans lequel au moins une quantité partielle ou tous les éléments d'actionneur de type MEMS (10) présentent une troisième structure d'électrodes commune (24) qui est disposée de manière fixe par rapport au substrat (12), et
dans lequel le dispositif de commande (22) est par ailleurs conçu pour fournir une autre tension de commande (V's) entre la deuxième et la troisième structure d'électrodes (16, 24).

11. Réseau d'actionneurs de type MEMS (100) selon l'une des revendications 8 à 10, dans lequel les éléments d'actionneur de type MEMS (10) présentent des éléments de micro-miroir (20) qui sont couplés, chacun, à l'une des deuxièmes structures d'électrodes (16), dans lequel les éléments de micro-miroir (20) peuvent être déviés selon la déviation de la deuxième structure d'électrodes (16).

12. Réseau d'actionneurs de type MEMS (100) selon l'une des revendications 8 à 11, dans lequel les deuxièmes structures d'électrodes (16) des éléments d'actionneur de type MEMS (10) peuvent être déviées, sur base de la tension de commande (Vs) vers au moins une position intermédiaire (z₁), chacune, entre la position de déviation minimale et maximale (Z_{MIN}, Z_{MAX}) et/ou, sur base de l'autre tension de commande (V'_{S}), vers au moins une position intermédiaire (z₁), chacune, entre la position de déviation minimale (Z_{MIN}) et une autre position de déviation maximale (Z'_{MAX}).

13. Réseau d'actionneurs de type MEMS (100) selon l'une des revendications 8 à 12, aux caractéristiques suivantes:
un plan arrière CMOS (12) comme substrat (12), où le plan arrière CMOS (12) présente le moyen de commande (22) et par ailleurs des cellules de mémoire (23).

14. Réseau d'actionneurs de type MEMS (100) selon l'une des revendications 8 à 13, dans lequel le réseau d'actionneurs de type MEMS (100) présente au moins 10.000 éléments d'actionneur de type MEMS (10).

15. Réseau d'actionneurs de type MEMS (100) selon l'une des revendications 8 à 14, dans lequel les éléments d'actionneur de type MEMS (10) présentent un pas (P) de moins de ou égal à 20µm.
